# EUROPEAN PATENT APPLICATION

(11) **EP 4 773 781 A1**
(43) Date of publication of application: **08.07.2026**
(21) Application number: 23962770.6
(22) Date of filing: 29.12.2023
(51) Int. Cl.: H10K 59/35

(54) **DISPLAY SUBSTRATE AND DISPLAY APPARATUS**

(71) Applicant: Boe Technology Group Co., Ltd., Beijing 100015 (CN); Chengdu BOE Optoelectronics Technology Co., Ltd., Chengdu, Sichuan 611731 (CN); Beijing BOE Technology Development Co., Ltd., Daxing District Beijing 100176 (CN)
(72) Inventor: HU, Ming, Beijing 100176 (CN); DONG, Xiangdan, Beijing 100176 (CN); LIU, Tingliang, Beijing 100176 (CN); FAN, Cong, Beijing 100176 (CN); WANG, Benlian, Beijing 100176 (CN); ZHANG, Wei, Beijing 100176 (CN); HAO, Xueguang, Beijing 100176 (CN); WANG, Hongli, Beijing 100176 (CN); QIU, Haijun, Beijing 100176 (CN); DU, Mengmeng, Beijing 100176 (CN); HUANG, Yao, Beijing 100176 (CN); YAN, Jun, Beijing 100176 (CN); TANG, Guoqiang, Beijing 100176 (CN)
(74) Representative: Brötz, Helmut
(86) International application number: PCT/CN2023/143188
(87) International publication number: WO 2025/138092

(57) **Abstract**

A display substrate and a display apparatus. The display substrate comprises a base substrate, sub-pixels located on the base substrate, and a limiting structure. The sub-pixel comprises a light-emitting functional layer, which comprises a plurality of film layers; and the limiting structure is located between two adjacent sub-pixels of different colors and is configured to partition at least one layer of the light-emitting functional layer. The sub-pixels comprise sub-pixels of a first color, and the limiting structure adjacent to the sub-pixels of the first color in the limiting structure is a first limiting structure; a light-emitting area of the sub-pixels of the first color comprises a first edge extending in a first direction; the first limiting structure comprises two limiting end points, wherein in the first direction, at least one limiting end point protrudes relative to an edge end point of the first edge, or the first limiting structure has a curved shape; and the total length of the first limiting structure is greater than the size of the light-emitting area of the sub-pixels of the first color in at least one direction, so that the low-grayscale crosstalk problem caused by leakage current between the sub-pixels of the first color and sub-pixels of other colors is mitigated.

## Description

### TECHNICAL FIELD

Embodiments of the present disclosure relate to a display substrate and a display device.

### BACKGROUND

With the development of display technology, users have higher and higher requirements on power consumption and service life of display devices. An organic light-emitting display device with a Tandem structure prolongs the life, improves the brightness and reduces the power consumption by additionally arranging at least one light-emitting layer and a charge generation layer, thereby meeting user requirements on power consumption and service life of the display devices.

### SUMMARY

The present disclosure provides a display substrate and a display device.

An embodiment of the present disclosure provides a display substrate, which includes a base substrate, and a plurality of sub-pixels and a plurality of defining structures located on the base substrate. Each of at least part of the sub-pixels includes a light-emitting functional layer which includes a plurality of film layers; and the plurality of defining structures is located between at least two adjacent sub-pixels with different colors, and configured to isolate at least one layer of the light-emitting functional layer; The plurality of sub-pixels includes a plurality of first color sub-pixels, and a defining structure, adjacent to at least one first color sub-pixel, in the plurality of defining structures is a first defining structure; at least part of the first defining structure extends in a first direction, a light-emitting region of the first color sub-pixel includes a first edge extending in the first direction; the first defining structure includes two defining end points; and in the first direction, at least one defining end point protrudes relative to an edge end point, close to the at least one defining end point, of the corresponding first edge, or, the first defining structure has a bent shape, and a total length of the first defining structure is larger than a size of the light-emitting region of the first color sub-pixel in at least one direction.

For example, according to an embodiment of the present disclosure, a distance between the two defining end points of the first defining structure is larger than a length of the first edge.

For example, according to an embodiment of the present disclosure, a total length of a part, extending in the first direction, of the first defining structure is larger than a length of the first edge.

For example, according to an embodiment of the present disclosure, a shape of a cross section, cut by a plane perpendicular to an extending direction of the defining structure includes an inverted trapezoid; a base angle between a waist of the inverted trapezoid and a base edge, away from the base substrate, of the inverted trapezoid ranges from 50° to 80°; a length of a base edge, close to the base substrate, of the inverted trapezoid ranges from 1 µm to 6 µm; and a thickness of the defining structure ranges from 0.8 µm to 1.8 µm.

For example, according to an embodiment of the present disclosure, an orthographic projection of the first edge on the base substrate is a first orthographic projection, an orthographic projection of the first defining structure on the base substrate is a second orthographic projection, and an orthographic projection of the first orthographic projection on a straight line extending in the first direction is completely located in an orthographic projection of the second orthographic projection on the straight line.

For example, according to an embodiment of the present disclosure, the light-emitting region of the first color sub-pixel further includes a second edge extending in a second direction, the second direction intersects with the first direction; and a distance between a straight line which has an orthographic projection of one of the two defining end points on the base substrate and extends in the second direction, and an orthographic projection of the second edge on the base substrate is less than 0.5 µm.

For example, according to an embodiment of the present disclosure, the plurality of sub-pixels includes a plurality of pixel units, the plurality of pixel units is arranged in an array along the first direction and the second direction, and the second direction intersects with the first direction; each pixel unit includes one first color sub-pixel, one second color sub-pixel and one third color sub-pixel; and the one first color sub-pixel and the one second color sub-pixel are arranged in the second direction, and the one second color sub-pixel and the one third color sub-pixel are arranged in the first direction; and at least one side of the same first color sub-pixel in the second direction is provided with the first defining structure which is closely adjacent to the first color sub-pixel.

For example, according to an embodiment of the present disclosure, the first color sub-pixel is a blue sub-pixel, one of the second color sub-pixel and the third color sub-pixel is a red sub-pixel, and the other one is a green sub-pixel.

For example, according to an embodiment of the present disclosure, the first defining structure is located between the first color sub-pixel and the second color sub-pixel, and a first distance between the first defining structure and a light-emitting region of the second color sub-pixel is less than a second distance between the first defining structure and the light-emitting region of the first color sub-pixel.

For example, according to an embodiment of the present disclosure, a difference between the second distance and the first distance is not less than 1 µm.

For example, according to an embodiment of the present disclosure, the first defining structure is located between the first color sub-pixel and the second color sub-pixel, and a ratio of a distance between the first defining structure and a light-emitting region of the second color sub-pixel to a distance between the first defining structure and the light-emitting region of the first color sub-pixel is 0.9-1.1.

For example, according to an embodiment of the present disclosure, at least one first defining structure includes two sub-defining structures which are arranged at intervals in the first direction; and a straight line extending in the second direction passes through an interval between orthographic projections of the two sub-defining structures on the base substrate and an interval between orthographic projections of light-emitting regions of the second color sub-pixel and the third color sub-pixel on the base substrate.

For example, according to an embodiment of the present disclosure, at least one first defining structure includes two sub-defining structures which are arranged at intervals in the first direction; and a straight line extending in the second direction passes through an interval between orthographic projections of the two sub-defining structures on the base substrate and an orthographic projection of a light-emitting region of the third color sub-pixel on the base substrate.

For example, according to an embodiment of the present disclosure, the plurality of defining structures further includes a plurality of second defining structures which are at least located between the second color sub-pixel and the third color sub-pixel adjacent to each other.

For example, according to an embodiment of the present disclosure, a third distance between the second defining structure and a light-emitting region of the second color sub-pixel is less than a fourth distance between the second defining structure and a light-emitting region of the third color sub-pixel.

For example, according to an embodiment of the present disclosure, a ratio of a distance between the second defining structure and a light-emitting region of the second color sub-pixel to a distance between the second defining structure and a light-emitting region of the third color sub-pixel is 0.9-1.1.

For example, according to an embodiment of the present disclosure, the display substrate further includes: a pixel defining pattern located on the base substrate, wherein the pixel defining pattern includes a plurality of openings and a pixel defining portion surrounding the openings, and the openings are configured to define the light-emitting regions of at least part of the sub-pixels; and a plurality of photo spacers located on a side, away from the base substrate, of the pixel defining pattern. A distance between light-emitting regions of adjacent sub-pixels is 10-30 µm; and the plurality of defining structures and the plurality of photo spacers are arranged in a same layer and are made of a same material, and a height of at least part of the photo spacers is larger than that of the plurality of defining structures.

For example, according to an embodiment of the present disclosure, the plurality of sub-pixels includes a plurality of second color sub-pixels and a plurality of third color sub-pixels; the plurality of sub-pixels are arranged into a plurality of first sub-pixel groups and a plurality of second sub-pixel groups which are alternately arranged in a third direction; each first sub-pixel group includes first color sub-pixels and second color sub-pixels which are alternately arranged in a fourth direction; each second sub-pixel group includes third color sub-pixels arranged in the fourth direction; the third direction intersects with the fourth direction; and the third direction and the fourth direction both intersect with the first direction; and the first defining structure is located between the first color sub-pixel and the third color sub-pixel, and a distance between the first defining structure and the light-emitting region of the first color sub-pixel is larger than a distance between the first defining structure and a light-emitting region of the third color sub-pixel.

For example, according to an embodiment of the present disclosure, an edge, adjacent to the first defining structure, of the third color sub-pixel extends in the first direction.

For example, according to an embodiment of the present disclosure, an edge of the light-emitting region of the third color sub-pixel has a curved shape, and the first defining structure is curved toward the light-emitting region of the third color sub-pixel.

For example, according to an embodiment of the present disclosure, the plurality of defining structures further includes a plurality of second defining structures which are at least located between adjacent second color sub-pixels and third color sub-pixels, and a distance between the second defining structure and the light-emitting region of the second color sub-pixel is less than a distance between the second defining structure and light-emitting region of the third color sub-pixel.

An embodiment of the present disclosure provides a display device, which includes any display substrate according as mentioned above.

### BRIEF DESCRIPTION OF DRAWINGS

In order to clearly illustrate the technical solution of the embodiments of the present disclosure, the drawings of the embodiments will be briefly described in the following; it is obvious that the described drawings are only related to some embodiments of the present disclosure and thus are not limitative of the present disclosure.
Fig. 1 and Fig. 2 are schematic diagrams of partial lamination structures of two different display substrates.
Fig. 3 is a schematic diagram of a partial planar structure of a display substrate according to an example of an embodiment of the present disclosure.
Fig. 4 is a schematic diagram of a partial cross-sectional structure cut along an AA' line shown in Fig. 3.
Fig. 5 is an enlarged diagram of a pixel unit shown in Fig. 3.
Fig. 6 is a schematic diagram of a cross section of a first defining structure 210 shown in Fig. 4 under a focused ion beam (FIB) microscope.
Fig. 7 is a schematic diagram of a partial planar structure of a display substrate according to another example of an embodiment of the present disclosure.
Fig. 8 is a schematic diagram of a planar structure of one pixel unit shown in Fig. 7.
Fig. 9 is a schematic diagram of a partial planar structure of a display substrate according to another example of an embodiment of the present disclosure.
Fig. 10 is a schematic diagram of a planar structure of one pixel unit shown in Fig. 9.
Fig. 11 is a schematic diagram of a partial planar structure of a display substrate according to another example of an embodiment of the present disclosure.
Fig. 12 is a schematic diagram of a planar structure of one pixel unit shown in Fig. 11.
Fig. 13 is a schematic diagram of a partial planar structure of a display substrate according to another example of an embodiment of the present disclosure.
Fig. 14 is a schematic diagram of a planar structure of one pixel unit shown in Fig. 13.
Fig. 15A and Fig. 15B are schematic diagrams of a planar structure of one pixel unit according to different examples of an embodiment of the present disclosure.
Fig. 16 is a schematic diagram of a partial planar structure of a display substrate according to another example of an embodiment of the present disclosure.
Fig. 17 is an enlarged diagram of a region B in the display substrate shown in Fig. 16.
Fig. 18 is a schematic diagram of a partial planar structure of a display substrate according to another example of an embodiment of the present disclosure.
Fig. 19 is a schematic block diagram of a display device according to another embodiment of the present disclosure.

### DETAILED DESCRIPTION

In order to make objects, technical details and advantages of the embodiments of the present disclosure apparent, the technical solutions of the embodiment will be described in a clearly and fully understandable way in connection with the drawings related to the embodiments of the present disclosure. It is obvious that the described embodiments are just a part but not all of the embodiments of the present disclosure. Based on the described embodiments herein, those skilled in the art can obtain other embodiment(s), without any inventive work, which should be within the scope of the present disclosure.

Unless otherwise defined, all the technical and scientific terms used herein have the same meanings as commonly understood by one of ordinary skill in the art to which the present disclosure belongs. The terms "first," "second," etc., which are used in the description and the claims of the present application for disclosure, are not intended to indicate any sequence, amount or importance, but distinguish various components. The terms "comprise," "comprising," "include," "including," etc., are intended to specify that the elements or the objects stated before these terms encompass the elements or the objects and equivalents thereof listed after these terms, but do not preclude the other elements or objects.

The features "parallel", "perpendicular" and "same" used in the embodiments of the present disclosure all include features such as "parallel", "perpendicular" and "same" in the strict sense, and the cases having certain errors, such as "approximately parallel", "approximately perpendicular", "approximately the same" or the like, taking into account measurements and errors associated with the measurement of a particular quantity (e.g., limitations of the measurement system), and indicate being within an acceptable range of deviation for a particular value as determined by one of ordinary skill in the art. For example, "approximately" may indicate being within one or more standard deviations, or within 10% or 5% of the stated value. In the case that the quantity of a component is not specifically indicated below in the embodiments of the present disclosure, it means that the component may be one or more, or may be understood as at least one. "At least one" means one or more, and "plurality" means at least two.

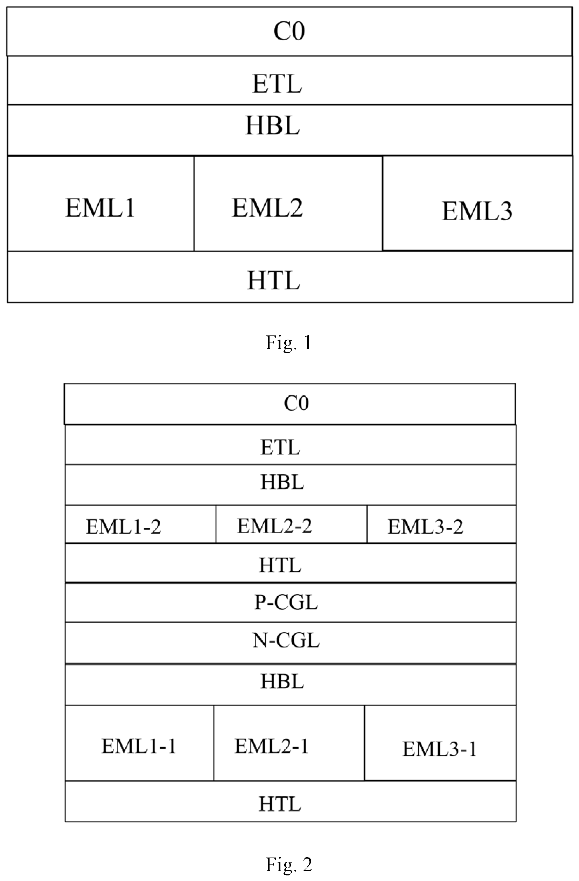

Fig. 1 and Fig. 2 are schematic diagrams of partial lamination structures of two different display substrates.

As shown in Fig. 1, a display substrate includes three light-emitting layers with different colors, including EML1, EML2 and EML3; a hole transport layer HTL is arranged on one side of the light-emitting layers; and a hole blocking layer HBL, an electron transport layer ETL and a cathode C0 which are sequentially laminated are arranged on the other side of the light-emitting layers. For example, the hole transport layer HTL, the hole blocking layer HBL, the electron transport layer ETL and the cathode C0 may be whole-surface film layers.

As shown in Fig. 2, a light-emitting functional layer in the display substrate includes a plurality of light-emitting layers which are laminated, such as a light-emitting layer EML1-1 and a light-emitting layer EML1-2 which are laminated, a light-emitting layer EML2-1 and a light-emitting layer EML2-2 which are laminated, and a light-emitting layer EML3-1 and a light-emitting layer EML3-2 which are laminated. For example, the light-emitting layer EML1-1 and the light-emitting layer EML1-2 can be light-emitting layers with the same color or different colors; the light-emitting layer EML2-1 and the light-emitting layer EML2-2 can be light-emitting layers with the same color or different colors; and the light-emitting layer EML3-1 and the light-emitting layer EML3-2 can be light-emitting layers with the same color or different colors. For example, the light-emitting layer EML1-1, the light-emitting layer EML2-1 and the light-emitting layer EML3-1 are light-emitting layers with different colors, and the light-emitting layer EML1-2, the light-emitting layer EML2-2 and the light-emitting layer EML3-2 are light-emitting layers with different colors.

As shown in Fig. 2, charge generation layers which are whole-surface film layers are arranged among the laminated light-emitting layers, for example, a P-type doped charge generation layer P-CGL and an N-type doped charge generation layer N-CGL, and the two charge generation layers can serve as common layers of the light-emitting functional layers. The P-type doped charge generation layer P-CGL and the N-type doped charge generation layer N-CGL are both whole-surface film layers. The charge generation layers have high electrical conductivity, and therefore the light-emitting functional layer has the advantages of long service life, low power consumption and capability of achieving high brightness.

An apparatus with the laminated light-emitting layers and charge generation layers can be called a Tandem apparatus. Compared with a display substrate without the Tandem apparatus in Fig. 1, the Tandem apparatus in the display substrate shown in Fig. 2 uses N/P-CGL as a heterojunction for connecting two light-emitting layers in a tandem way; this technology achieves series connection of double light-emitting apparatuses; and under the same light-emitting intensity, the light-emitting current of the light-emitting apparatuses is greatly reduced, the service life of the organic light-emitting element is prolonged, and the power consumption is reduced.

As shown in Fig. 2, the hole blocking layer HBL can be arranged between the charge generation layer N-CGL and the light-emitting layer; the hole transport layer HTL can be arranged between the charge generation layer P-CGL and the light-emitting layer; the hole transport layer HTL can be arranged on the side, away from the hole blocking layer HBL, of the light-emitting layer EML1-1; and the hole blocking layer HBL, the electron transport layer ETL and the cathode C0 can be sequentially arranged on the side, away from the hole transport layer HTL, of the light-emitting layer EML 1-2. For example, the hole transport layer HTL, the hole blocking layer HBL, the electron transport layer ETL and the cathode C0 are all whole-surface film layers.

During the research, the inventors of the present application found that the charge generation layers of two adjacent sub-pixels in the Tandem apparatus are continuous film layers, and there is a lateral charge migration phenomenon, which causes the display substrate to have a monochrome chromaticity shift phenomenon at low grayscale, such as easily causing crosstalk between adjacent sub-pixels, resulting in color deviation of the display substrate.

The present disclosure provides a display substrate and a display device. The display substrate includes a base substrate, a plurality of sub-pixels and a plurality of defining structures located on the base substrate. Each of at least part of the sub-pixels includes a light-emitting functional layer which includes a plurality of film layers; the plurality of defining structures are located between at least two adjacent sub-pixels of different colors, and are configured to isolate at least one layer of the light-emitting functional layer. The plurality of sub-pixels includes a plurality of first color sub-pixels, and a defining structure, adjacent to at least one first color sub-pixel, in the plurality of defining structures is a first defining structure; at least part of the first defining structure extends in a first direction; a light-emitting region of the first color sub-pixel includes a first edge extending in the first direction; the first defining structure includes two defining end points; and in the first direction, at least one defining end point protrudes relative to an edge end point, adjacent to the at least one defining end point, of the first edge, or, the first defining structure has a bent shape, and a total length of the first defining structure is larger than a size of the light-emitting region of the first color sub-pixel in at least one direction.

According to the display substrate provided by the embodiments of the present disclosure, the first defining structure is arranged to isolate the at least one layer of the light-emitting functional layer, at the same time, the defining end point of the first defining structure is arranged to protrude relative to the edge end point of the first edge, or the total length of the first defining structure is set to be larger than the size of the light-emitting region of the first color sub-pixel in the at least one direction, thus the low-grayscale crosstalk problem caused by leakage of current between the first color sub-pixel and other color sub-pixels is reduced, and moreover, the possibility that the first defining structure is peeled is reduced.

The display substrate and the display device provided by the embodiments of the present disclosure are described in cooperation with the following accompanying drawings.

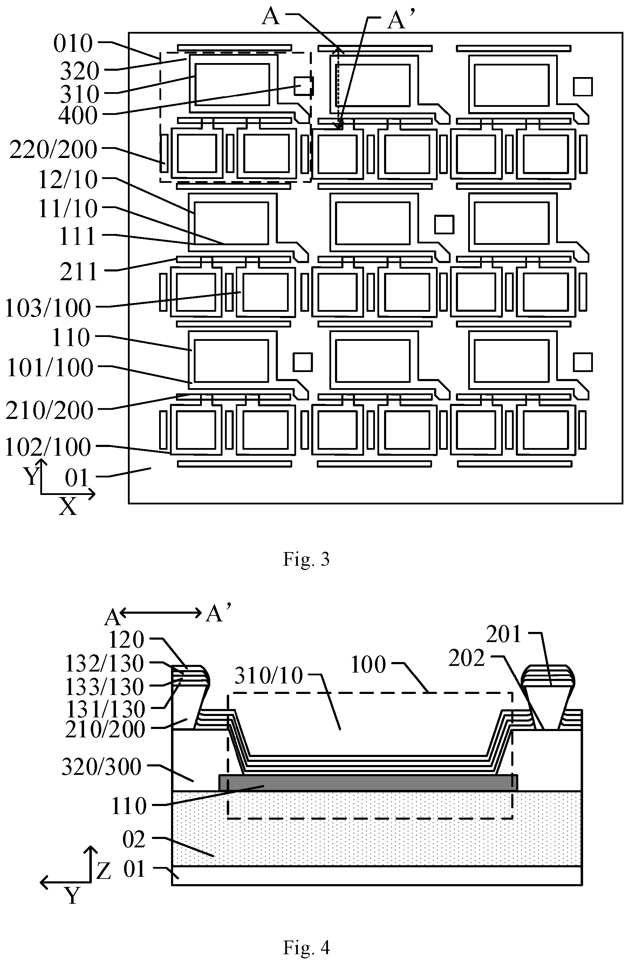

Fig. 3 is a schematic diagram of a partial planar structure of a display substrate according to an example of embodiments of the present disclosure. Fig. 4 is a schematic diagram of a partial cross-sectional structure cut along an AA' line shown in Fig. 3.

As shown in Fig. 3 and Fig. 4, the display substrate includes a base substrate 01, a plurality of sub-pixels 100 and a plurality of defining structures 200 located on the base substrate 01. Each sub-pixel 100 in at least part of the sub-pixels 100 includes a light-emitting functional layer 130, and the light-emitting functional layer 130 includes a plurality of film layers. For example, at least part of the sub-pixels 100 is located in a display region of the display substrate, namely a region for displaying an image, and the display substrate further includes a peripheral region surrounding the display region.

For example, as shown in Fig. 4, each sub-pixel 100 further includes a first electrode 110 and a second electrode 120 which are located on two sides of the light-emitting functional layer 130 in a direction perpendicular to the base substrate 01 (Z direction shown in Fig. 4), and the first electrode 110 is located between the light-emitting functional layer 130 and the base substrate 01.

For example, as shown in Fig. 4, the light-emitting functional layer 130 may include a light-emitting layer for emitting light and a charge generation layer 133. For example, the light-emitting functional layer 130 may be a film layer in an organic light-emitting element. For example, the light-emitting functional layer 130 may include a first light-emitting layer (EML) 131, a charge generation layer (CGL) 133 and a second light-emitting layer (EML) 132 which are laminated; and the charge generation layer 133 is located between the first light-emitting layer 131 and the second light-emitting layer 132. As shown in Fig. 2, the thickness of a plurality of film layers included in the light-emitting functional layer 130 is only used for clearly illustrating each film layer and does not represent the actual size.

For example, as shown in Fig. 4, the charge generation layer 133 has high conductivity, so that the light-emitting functional layer 130 has the advantages of long service life, low power consumption and capability of achieving high brightness. For example, the same sub-pixel may include a tandem type light-emitting element, such as a Tandem OLED. Certainly, the embodiments of the present disclosure are not limited to it, and the light-emitting functional layer 130 of each sub-pixel 100 may only include one light-emitting layer.

For example, in the same sub-pixel 100, the first light-emitting layer 131 and the second light-emitting layer 132 can be the light-emitting layers emitting light with the same color. For example, the first light-emitting layer 131 emitting light with different colors in the sub-pixel 100 emits light with different colors. For example, the second light-emitting layer emitting light with different colors 132 in the sub-pixel 100 emits light with different colors. Certainly, the embodiments of the present disclosure are not limited to it, for example, in the same sub-pixel 100, the first light-emitting layer 131 and the second light-emitting layer 132 may be the light-emitting layers emitting light with different colors; the light-emitting layers emitting light with different colors are arranged in the same sub-pixel 100, so the light emitted by the plurality of light-emitting layers in the sub-pixel 100 can be mixed into white light; and a color film layer can be arranged to adjust the color of light emitted by each sub-pixel 100.

For example, in each sub-pixel 100, the light-emitting functional layer 130 may further include a hole injection layer (HIL), a hole transport layer (HTL), an electron transport layer (ETL), and an electron injection layer (EIL).

For example, the hole injection layer, the hole transport layer, the electron transport layer, the electron injection layer, the charge generation layer 133, and the second electrode 120 are all common film layers of the plurality of sub-pixels 100, and may be referred to as the common layers.

For example, the second light-emitting layer 132 can be located between the first light-emitting layer 131 and the second electrode 120, and the hole injection layer can be located between the first electrode 110 and the first light-emitting layer 131. For example, the electron transport layer may further be arranged between the charge generation layer 133 and the first light-emitting layer 131. For example, the hole transport layer can be arranged between the second light-emitting layer 132 and the charge generation layer 133. For example, the electron transport layer and the electron injection layer can be arranged between the second light-emitting layer 132 and the second electrode 120.

For example, the charge generation layer 133 may include an N-type charge generation layer and a P-type charge generation layer.

For example, the material of the electron transport layer may include aromatic heterocyclic compounds, e.g., imidazole derivatives such as benzimidazole derivatives, imidazopyridine derivatives, benzimidazole phenanthridine derivatives, etc.; zine derivatives such as pyrimidine derivatives, triazine derivatives, etc.; compounds containing a nitrogen-containing six-membered ring structure such as quinoline derivatives, isoquinoline derivatives, phenanthroline derivatives, etc. (compounds with phosphine oxide substituents on a heterocyclic ring are also included), or the like.

For example, the material of the charge generation layer 133 may be a material containing a phosphorus oxygen group, and may also be a material containing triazine.

For example, the ratio of the electron mobility of the material of the charge generation layer 133 to the electron mobility of the electron transport layer is 10⁻²-10².

For example, the first electrode 110 may be an anode, and the second electrode 120 may be a cathode. For example, the cathode may be made of a material having high conductivity and low work function, for example, the cathode may be made of metal material. For example, the anode may be made of a transparent conductive material having high work function.

For example, as shown in Fig. 4, the side, facing the base substrate 01, of the first electrode 110 is also provided with other structures 02, for example, a pixel circuit electrically connected to the first electrode 110 of the sub-pixel 100, a signal line and respective insulating layers, for example, a planarization layer, a passivation layer, a buffer layer, a gate insulating layer and an interlayer insulating layer.

As shown in Fig. 3 and Fig. 4, the plurality of defining structures 200 are located between at least two adjacent sub-pixels 100 with different colors, and are configured to isolate at least one layer of the light-emitting functional layer 130. For example, at least one film layer, isolated at the edge of the corresponding defining structure 200, in each light-emitting functional layer 130 can be at least one film layer in the common layers as mentioned above. For example, all film layers of the light-emitting functional layers 130 and the second electrode 120 are isolated by the defining structures 200. By isolating the at least one film layer in the above common layers at the edge of the defining structure 200 between two adjacent sub-pixels 100 with different colors, the probability of crosstalk between the adjacent sub-pixels 100 can be reduced. For example, the above common layers and the second electrode 120 can be film layers formed by an open mask 310.

As shown in Fig. 3 and Fig. 4, the plurality of sub-pixels 100 includes a plurality of first color sub-pixels 101, and a defining structure 200, adjacent to at least one first color sub-pixel 101, in the plurality of defining structures 200 is a first defining structure 210. For example, the defining structures 200, adjacent to respective first color sub-pixels 101, in the plurality of defining structures 200 are first defining structures 210. The defining structure 200 adjacent to the first color sub-pixels 101 being the first defining structure 210 may refer to that the first defining structure 210 is closest to light-emitting region 10 of the first color sub-pixel 101; for example, there is no other defining structure 200 between the first defining structure 210 and the light-emitting region 10 of the first color sub-pixel 101, the distance between the other defining structure 200 and the light-emitting region 10 of the first color sub-pixel 101 is larger than the distance between the first defining structure 210 and the light-emitting region 10 of the first color sub-pixel 101.

As shown in Fig. 3, at least part of the first defining structure 210 extends in a first direction, and the first defining structure 210 includes two defining end points 211. As schematically shown in Fig. 3, the first direction is the X direction, but is not limited thereto, the first direction may also be a direction opposite to the direction pointed by the arrow in the X direction. For example, the two defining end points 211 of the first defining structure 210 can be points on the two ends of the two sides of the first defining structure 210 in the first direction, such as two points with the farthest distance on the two ends.

As shown in Fig. 3, the light-emitting region 10 of the first color sub-pixel 101 includes a first edge 11 extending in the first direction, and in the first direction, at least one defining end point 211 protrudes relative to an edge end point 111, adjacent to the at least one defining end point 211, of the first edge 11. For example, a straight line extending in the direction perpendicular to the first direction (the Y direction or the direction opposite to the direction indicated by the arrow in the Y direction shown in Fig. 3) passes through an orthographic projection of the at least one defining end point 211 as mentioned above on the base substrate 01, but does not pass through the orthographic projection of the first edge 11 as mentioned above on the base substrate 01. For example, the straight line extending in the direction perpendicular to the first direction passes through the orthographic projection of the edge end point 111 of the first edge 11 as mentioned above on the base substrate 01, and passes through the orthographic projection of the first defining structure 210 as mentioned above on the base substrate 01.

According to the display substrate provided by the embodiment of the present disclosure, by setting the first defining structure to disconnect at least one layer of the light-emitting functional layer, and setting the defining end point of the first defining structure to protrude relative to the edge end point of the first edge at the same time, it is beneficial to reduce the problem of low-gray-scale crosstalk caused by leakage current between the first color sub-pixel and other color sub-pixels, and at the same time reduce the possibility of the first defining structure peeling off.

In some examples, as shown in Fig. 3, the distance between two defining end points 211 of the first defining structure 210 is larger than the length of the first edge 11. For example, each first defining structure 210 in the display substrate shown in Fig. 3 includes a continuous long-strip-shaped structure, and the distance between the two defining end points 211 of the first defining structure 210 can be the length of the first defining structure 210 in the first direction, for example, the length of the first defining structure 210 is larger than the length of the first edge 11.

In some examples, as shown in Fig. 3, the total length of the parts, extending in the first direction, of the first defining structure 210 is larger than the length of the first edge 11. For example, the first defining structure 210 extends in the first direction, and the total length of the first defining structure 210 is larger than the length of the first edge 11.

For example, in the display substrate shown in Fig. 3, one first defining structure 210 is arranged corresponding to the same first color sub-pixel 101 and is located on the same side of the first color sub-pixel 101, namely a continuous long-strip-shaped structure, the total length of the first defining structure 210 is the length of the first defining structure 210, and for example, the length of the first defining structure 210 is larger than the length of the first edge 11.

In some examples, as shown in Fig. 3, an orthographic projections of the first edge 11 on the base substrate 01 is a first orthographic projection, an orthographic projection of the first defining structure 210 on the base substrate 01 is a second orthographic projection, and an orthographic projection, on the straight line extending in the first direction, of the first orthographic projection is completely located in an orthographic projection, on the straight line, of the second orthographic projection. For example, two defining end points 211 of the first defining structure 210 both protrude outwards relative to the two edge end points 111 of the first edge 11. The length of the first defining structure 210 is set to be larger than the length of the first edge 11, and meanwhile, the two defining end points 211 of the first defining structure 210 are set to protrude outwards relative to the two edge end points 111 of the first edge 11, so that crosstalk between the first color sub-pixel 101 and other color sub-pixels 100 can be further reduced, and the leakage current isolation effect is improved.

In some examples, as shown in Fig. 3, the plurality of sub-pixels 100 includes a plurality of pixel units 010, the plurality of pixel units 010 is arranged in an array along the first direction and the second direction, and the second direction intersects with the first direction. For example, the first direction is the X direction, and the second direction is the Y direction. Each pixel unit 010 includes one first color sub-pixel 101, one second color sub-pixel 102 and one third color sub-pixel 103; and the first color sub-pixel 101 and the second color sub-pixel 102 are arranged in the second direction, and the second color sub-pixel 102 and the third color sub-pixel 103 are arranged in the first direction. For example, the sub-pixels in each pixel unit 010 are arranged in a Real RGB pixel arrangement.

In some examples, as shown in Fig. 3, the first defining structure 210 is arranged on at least one side of the same first color sub-pixel 101 in the second direction. For example, the first defining structures 210 are arranged on two sides of the same first color sub-pixel 101 in the second direction.

In some examples, as shown in Fig. 3, the first color sub-pixel 101 is a blue sub-pixel, one of the second color sub-pixel 102 and the third color sub-pixel 103 is a red sub-pixel, and the other one is a green sub-pixel. For example, the second color sub-pixel 102 is the red sub-pixel, and the third color sub-pixel 103 is the green sub-pixel. Certainly, the embodiments of the present disclosure are not limited to the second color sub-pixel 102 being the red sub-pixel and the third color sub-pixel 103 being the green sub-pixel, for example, the colors of the second color sub-pixel 102 and the third color sub-pixel 103 can be interchanged.

For example, as shown in Fig. 3, each side of the same first-color sub-pixel 101 in the second direction is provided with one first defining structure 210, and distances between two first defining structures 210 located on the two sides of the first color sub-pixel 101 and the light-emitting region 10 of the first color sub-pixel 101 are equal. For example, while the first defining structure 210 is located between the first color sub-pixel 101 and the second color sub-pixel 102, the first defining structure 210 is located between the first color sub-pixel 101 and the third color sub-pixel 103. The first defining structure 210 is arranged between the first color sub-pixel 101 and the second color sub-pixel 102, as well as between the first color sub-pixel 101 and the third color sub-pixel 103, it is beneficial to simultaneously improve the leakage current blocking effect of the first defining structure 210 between the first color sub-pixel 101 and the second color sub-pixel 102, as well as the leakage current blocking effect of the first defining structure 210 between the first color sub-pixel 101 and the third color sub-pixel 103.

In some examples, as shown in Fig. 3, the first defining structure 210 is located between the first color sub-pixel 101 and the second color sub-pixel 102, and the ratio of the distance between the first defining structure 210 and the light-emitting region 10 of the second color sub-pixel 102 to the distance between the first defining structure 210 and the light-emitting region 10 of the first color sub-pixel 101 is 0.9-1.1. For example, the first color sub-pixel 101 and the second color sub-pixel 102 are located on the two sides of the first defining structure 210 respectively, and the distance between the first defining structure 210 and the light-emitting region 10 of the first color sub-pixel 101 is equal to the distance between the first defining structure 210 and the light-emitting region 10 of the second color sub-pixel 102. For example, the first color sub-pixel 101 and the third color sub-pixel 103 are located on two sides of the first defining structure 210 respectively, and the distance between the first defining structure 210 and the light-emitting region 10 of the first color sub-pixel 101 is equal to the distance between the first defining structure 210 and the light-emitting region 10 of the third color sub-pixel 103.

In some examples, as shown in Fig. 3, the light-emitting region 10 of each first color sub-pixel 101 further includes a second edge 12 extending in the second direction, the second direction intersects with the first direction, for example, the second direction is the Y direction as shown in Fig. 3, for example, the first direction is perpendicular to the second direction. For example, the first direction and the second direction can be interchanged. For example, the shape of the light-emitting region 10 of each first color sub-pixel 101 can be quadrangle, such as rectangle. For example, the length of the first edge 11 of the light-emitting region 10 of each first color sub-pixel 101 is larger than the length of the second edge 12.

For example, as shown in Fig. 3, an extension line of an orthographic projection of the second edge 12 of the first color sub-pixel 101 on the base substrate 01 passes through the orthographic projection of the first defining structure 210 on the base substrate 01. For example, the extension line of the orthographic projection of the second edge 12 of the first color sub-pixels 101 on the base substrate 01 passes through the orthographic projections of the light-emitting regions 10 of at least one of the second color sub-pixel 102 and the third color sub-pixel 103 on the base substrate 01.

For example, as shown in Fig. 3, three sub-pixels 100 in the same pixel unit 010 are arranged in a triangle form. For example, the second color sub-pixel 102 and the third color sub-pixel 103 are located in the same row, and the edges of the light-emitting regions 10 of the second color sub-pixel 102 and the third color sub-pixel 103 are located on the two sides of the first defining structure 210 in the first direction, thus improving the width of a conduction channel of the second electrode 120.

For example, as shown in Fig. 3, the first electrode 110 of each sub-pixel 100 includes a main electrode overlapped with the corresponding light-emitting region 10 and a connecting electrode electrically connected to a pixel circuit, and the main electrode and the connecting electrode are of an integrally arranged structure. For example, the shape of each main electrode is similar to that of the corresponding light-emitting region 10. For example, the connecting electrode of each first color sub-pixel 101 is located between the light-emitting regions 10 of two adjacent first color sub-pixels 101, and the straight line extending in the second direction passes through the orthographic projection of the connecting electrode of each first color sub-pixel 101 on the base substrate 01 and an interval between the orthographic projections, on the base substrate 01, of the light-emitting regions 10 of second color sub-pixels 102 and the third color sub-pixels 103 which are adjacently arranged. For example, in the same pixel unit 010, the connecting electrode of the second color sub-pixel 102 is located between the light-emitting regions 10 of the first color sub-pixel 101 and the second color sub-pixel 102, and the connecting electrode of the third color sub-pixel 103 is located between the light-emitting regions 10 of the first color sub-pixel 101 and the third color sub-pixel 103.

For example, as shown in Fig. 3, in the direction perpendicular to the base substrate 01, the connecting electrode of the first electrode 110 of each first color sub-pixel 101 is not overlapped with the first defining structure 210, and the connecting electrode of the first electrode 110 of at least one of each second color sub-pixel 102 and each third color sub-pixel 103 is overlapped with the first defining structure 210. For example, the straight line extending in the first direction passes through the orthographic projection of the first defining structure 210 on the base substrate 01 and the orthographic projection of the connecting electrode of the first color sub-pixel 101 on the base substrate 01; in the direction perpendicular to the base substrate 01, the connecting electrodes of the first electrodes 110 of the second color sub-pixel 102 and the third color sub-pixel 103 both overlap with the first defining structure 210, so that it is guaranteed that the interval between the sub-pixels 100 is small, and meanwhile, the crosstalk between the first color sub-pixel 101 and other color sub-pixels 100 is reduced by arranging the first defining structure 210.

In some examples, as shown in Fig. 3, the plurality of defining structures 200 further includes a plurality of second defining structures 220 which are at least located between adjacent second color sub-pixel 102 and third color sub-pixel 103. For example, the second color sub-pixels 102 and the third color sub-pixels 103 are alternately arranged in the first direction, and the second defining structure 220 extending in the second direction is arranged between any adjacent second color sub-pixels 102 and third color sub-pixels 103.

For example, as shown in Fig. 3, the light-emitting regions 10 of the second color sub-pixels 102 and the third color sub-pixels 103 are quadrilateral, such as rectangular. For example, the area of the light-emitting region 10 of each first color sub-pixel 101 is larger than that of the light-emitting region 10 of each third color sub-pixel 103, and the area of the light-emitting region 10 of each third color sub-pixel 103 is larger than that of the light-emitting region 10 of each second color sub-pixel 102. For example, the length of the edge, extending in the first direction, of the light-emitting region 10 of each third color sub-pixel 103 is larger than that of the edge, extending in the first direction, of the light-emitting region 10 of each second color sub-pixel 102; and the length of the edge, extending in the second direction, of the light-emitting region 10 of each third color sub-pixel 103 is equal to that of the edge, extending in the second direction, of the light-emitting region 10 of each second color sub-pixel 102.

In some examples, as shown in Fig. 3, the ratio of the distance between the second defining structure 220 and the light-emitting region 10 of the second color sub-pixel 102 to the distance between the second defining structure 220 and the light-emitting region 10 of the third color sub-pixel 103 is 0.9-1.1. For example, the distance between the second defining structure 220 and the light-emitting region 10 of the second color sub-pixel 102 is equal to the distance between the second defining structure 220 and the light-emitting region 10 of the third color sub-pixel 103.

For example, as shown in Fig. 3, the ratio of the length of the second defining structure 220 to the size of the light-emitting region 10 of the second color sub-pixel 102 in the second direction is 0.8-1.2, such as 0.9-1.1, such as 1.

For example, as shown in Fig. 3, the straight line extending in the second direction passes through the orthographic projection of the second defining structure 220 on the base substrate 01 and the orthographic projection of the connecting electrode of the first color sub-pixel 101 on the base substrate 01. For example, the straight line extending in the first direction passes through the first defining structure 210, but does not pass through the second defining structure 220. For example, a certain interval is formed between the first defining structure 210 and the second defining structure 220.

In some examples, as shown in Fig. 3 and Fig. 4, the display substrate further includes a pixel defining pattern 300 (PDL) located on the base substrate 01; the pixel defining pattern 300 includes a plurality of openings 310 and a pixel defining portion 320 surrounding the openings 310; and the openings 310 are configured to define the light-emitting regions 10 of at least part of the sub-pixels 100.

For example, as shown in Fig. 3 and Fig. 4, one sub-pixel 100 corresponds to at least one opening 310, at least part of the light-emitting functional layer 130 of the sub-pixel 100 is located in the opening 310 corresponding to the sub-pixel 100, and the opening 310 is configured to expose the first electrode 110.

For example, as shown in Fig. 4, when the light-emitting functional layer 130 is formed in the opening 310 of the pixel defining pattern 300, the first electrode 110 and the second electrode 120 located on the two sides of the light-emitting functional layer 130 can drive the light-emitting functional layer 130 in the opening 310 to emit light. For example, the openings 310 of the pixel defining pattern 300 are used for defining the light-emitting regions 10 of the sub-pixels 100. The light-emitting regions 10 may be effective light-emitting areas of the sub-pixels 100, the shape of the light-emitting regions 10 is a two-dimensional shape, and for example, the shape of the light-emitting regions 10 can be the same as the shapes of the openings 310 of the pixel defining pattern 300.

For example, as shown in Fig. 4, the material of the pixel defining portion 320 may include polyimide, acrylic or polyethylene terephthalate and the like.

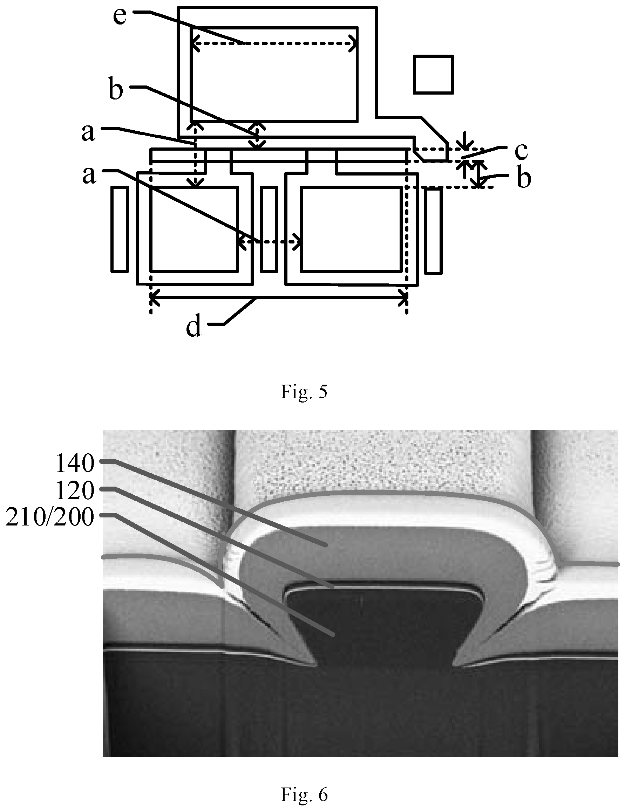

Fig. 5 is an enlarged diagram of a pixel unit shown in Fig. 3.

For example, as shown in Fig. 3 and Fig. 5, the distance (such as PDL gap) between the light-emitting regions 10 of adjacent sub-pixels 100 is *a*; the distances between the first defining structures 210 and the light-emitting regions 10 of the sub-pixels 100 are all *b*; the length of the side, close to the base substrate 01, of the section of the first defining structure 210 in the direction perpendicular to the first direction is *c*; the length of the first defining structure 210 is *d*; the length of the first edge 11 of the light-emitting region 10 of the first color sub-pixel 101 is *e*; *a* ranges from 10 µm to 30 µm, such as 15 µm to 25 µm, *b=a*/2-*c*; *c* ranges from 1 µm to 6 µm; and *e<d*. The distance between the first defining structure 210 and the light-emitting region 10 of the sub-pixel 100 may be the distance between the first defining structure 210 and the edge, close to each other, of the light-emitting region 10.

For example, as shown in Fig. 5, *a* ranges from 12 µm to 25 µm, or from 15 µm to 20 µm, or from 18 µm to 28 µm, which is not limited. For example, c ranges from 2 µm to 4 µm or from 3 µm to 5 µm, which is not limited.

For example, as shown in Fig. 3 and Fig. 5, the distance between the second defining structure 220 and the light-emitting region 10 of the second color sub-pixel 102 can be no larger than the distance between the first defining structure 210 and the light-emitting region 10, for example, the two distances are equal, or the former is less than the latter.

Fig. 6 is a schematic diagram of a cross section of the first defining structure 210 shown in Fig. 4 under a focused ion beam (FIB) microscope.

In some examples, as shown in Fig. 4 and Fig. 6, the shape of the cross section, cut by a plane perpendicular to the extending direction of the defining structure 200, such as the first defining structure 210, includes an inverted trapezoid, a base angle between the waist of the inverted trapezoid and the base edge 201, away from the base substrate 01, of the inverted trapezoid ranges from 50° to 80°, the length of the base edge 202, close to the base substrate 01, of the inverted trapezoid ranges from 1 µm to 6 µm, and the thickness of the defining structure 200, such as the first defining structure 210, ranges from 0.8 µm to 1.8 µm. By arranging the shape of the defining structure 200, such as the first defining structure 210, at least one layer in the light-emitting functional layer 130 can be isolated by the first defining structure 210.

For example, as shown in Fig. 4 and Fig. 6, the base angle between the waist of the inverted trapezoid and the base edge 201, away from the base substrate 01, of the inverted trapezoid can range from 55° to 70°, or 60° to 75° or the like, which will not be listed in the embodiment of the present disclosure. For example, the length of the base edge 202, close to the base substrate 01, of the inverted trapezoid can range from 2 µm to 4 µm, or 3 µm to 6 µm, or 2.5 µm to 5 µm, or the like, which will not be listed in the embodiment of the present disclosure. For example, the thickness of the defining structure 200, such as the first defining structure 210, ranges from 1 µm to 1.5 µm, or 1.2 µm to 1.6 µm, or the like, which will not be listed in the embodiments of the present disclosure.

For example, as shown in Fig. 3 and Fig. 4, the cross section, cut by the plane perpendicular to the Y direction, of the second defining structure 220 may have the same characteristics as the cross section of the first defining structure 210, which will not be repeated here.

According to the display substrate provided by the embodiment of the present disclosure, the relative position relationship, relative spacing, relative size and other relationships between the defining structures and the sub-pixels of different colors are limited, thus reducing poor crosstalk display caused by materials in the light-emitting functional layer of different sub-pixels.

For example, as shown in Fig. 6, an encapsulation layer 140 is further arranged on the side, away from the base substrate 01, of the second electrode 120 of each sub-pixel 100. For example, the encapsulation layer 140 may include an inorganic encapsulation layer, an organic encapsulation layer and an inorganic encapsulation layer which are sequentially laminated.

In some examples, as shown in Fig. 3 and Fig. 4, the display substrate further includes a plurality of photo spacers 400 located on the sides, away from the base substrate 01, of the pixel defining portion 320. For example, the photo spacers 400 (PS) are configured to support a fine metal mask (FMM Mask) when the light-emitting layers are manufactured.

In some examples, as shown in Fig. 3 and Fig. 4, the plurality of defining structures 200 and the plurality of photo spacers 400 are arranged in the same layer and are made of the same material, and the height of at least part of the photo spacers 400 is larger than that of the plurality of defining structures 200. For example, negative photoresist can be adopted as the materials of the defining structures 200 and the photo spacers 400.

For example, as shown in Fig. 3 and Fig. 4, in order to reduce the production cost of the mask and simplify the production process flow, the defining structures 200 for isolating the at least one layer in the light-emitting functional layer 130 and the photo spacers 400 for supporting the FMM Mask can be manufactured by the same Halftone Mask in the embodiments of the present disclosure, for example, the Mask correspondingly adopts a first transmittance Tr1 at positions for forming the defining structures 200 in the materials to be manufactured into the defining structures 200 and the photo spacers 400, the Mask correspondingly adopts a second transmittance Tr2 at the positions for forming the photo spacers 400, and the first transmittance Tr1 is greater than the second transmittance Tr2, thus the thickness of the defining structures 200 is less than that of the photo spacers 400, and problems of dark spots or color mixing and the like caused by FMM mask scratching due to the defining structures 200 are avoided. For example, the difference between the thickness of the defining structures 200 and the height of the photo spacers 400 can be 0.3 µm or above, such as 0.4 µm, 0.5 µm or 0.6 µm, which will not be listed here. For example, the transmittance Tr1 can be 50%, and the transmittance Tr2 can be 0%. The defining structures 200 and the photo spacers 400 are arranged in the same layer and are made of the same material, so that the defining structures 200 and the photo spacers 400 can be manufactured by a one-step patterning process to save the process steps. Certainly, the embodiments of the present disclosure are not limited thereto, and the defining structures 200 can also be made of the same material as the pixel defining portions 320, such as a structure integrally arranged with the pixel defining portions 320.

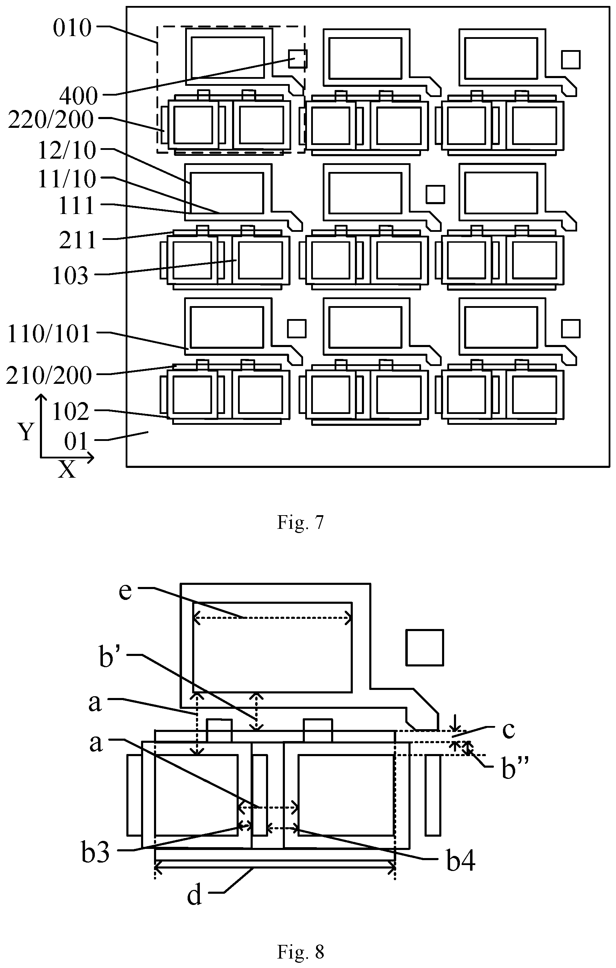

Fig. 7 is a schematic diagram of a partial planar structure of a display substrate according to another example of an embodiment of the present disclosure. Fig. 8 is a schematic diagram of a planar structure of one pixel unit shown in FIG. 7. The difference between the display substrate shown in Fig. 7 and Fig. 8 and the display substrate shown in Fig. 3 and Fig. 5 is the distance between the first defining structure 210 and the first color sub-pixel 101.

In some examples, as shown in Fig. 7 and Fig. 8, the first defining structure 210 is located between the first color sub-pixel 101 and the second color sub-pixel 102, and a first distance b'' between the first defining structure 210 and the light-emitting region 10 of the second color sub-pixel 102 is less than a second distance b' between the first defining structure 210 and the light-emitting region 10 of the first color sub-pixel 101. The data writing voltages of the sub-pixels 100 of different color have differences, so when a low-grayscale display picture is caused, the blue sub-pixel and the green sub-pixel are easily subjected to current leakage of the red sub-pixel to cause low grayscale, for example, the red sub-pixel is in crosstalk with the blue sub-pixel or the green sub-pixel, therefore, in the display substrate provided by the example, the first defining structure 210 is arranged to be closer to the red sub-pixel, thus the channel proportion of the light-emitting functional layer 130 around the light-emitting region 10 of the red sub-pixel can be reduced, and the crosstalk effect is reduced.

In some examples, as shown in Fig. 7 and Fig. 8, the difference between the second distance b' and the first distance b" is not less than 1 µm. For example, the difference between the second distance b' and the first distance b" is not less than 1.2 µm, or 1.5 µm and the like, which will not be listed in the embodiments of the present disclosure.

For example, as shown in Fig. 7 and Fig. 8, the *a*, *c*, *d*, *e* and the size relationship between *d* and *e* may be the same as relevant parameters shown in Fig. 5, which will not be listed here. For example, the distance b' between the first defining structure 210 and the light-emitting region 10 of the blue sub-pixel is at least 1 µm larger than the distance b'' between the first defining structure 210 and the light-emitting region 10 of the red sub-pixel or the green sub-pixel.

For example, as shown in Fig. 7 and Fig. 8, b" and *a* as well as *c* meet the relational expression 2≤b" ≤(*a-c*)/2, and b' and *a,* b" and *c* meet the relational expression b'= a-c- b". For example, the numerical value of b" can be 2-10 µm, and the numerical value of b' can be 10-15 µm. For example, b" can be 3 µm, or 4 µm, or 5 µm and the like, b" can be any numerical value between 2 µm and 10 µm, which will not be listed here. For example, b' can be 12 µm, or 14 µm and the like, b' can be any numerical value between 10 µm and 15 µm, which will not be listed here.

In some examples, as shown in Fig. 7 and Fig. 8, a third distance b3 between the second defining structure 220 and the light-emitting region 10 of the second color sub-pixel 102 is less than a fourth distance b4 between the second defining structure 220 and the light-emitting region 10 of the third color sub-pixel 103. For example, the second defining structure 220 is closer to the second color sub-pixel 102. Therefore, according to the display substrate provided by the example, the first defining structure 210 is arranged to be closer to the second color sub-pixel 102, such as the red sub-pixel, so that the channel proportion of the light-emitting functional layer 130 around the light-emitting region 10 of the red sub-pixel can be reduced, and the crosstalk effect is reduced.

For example, as shown in Fig. 7, the ratio of the distance between the first defining structure 210 and the light-emitting region 10 of the second color sub-pixel 102 to the distance between the second defining structure 220 and the light-emitting region 10 of the second color sub-pixel 102 is 0.9-1.1. For example, the distance between the first defining structure 210 and the light-emitting region 10 of the second color sub-pixel 102 is equal to the distance between the second defining structure 220 and the light-emitting region 10 of the second color sub-pixel 102. For example, the distance between the first defining structure 210 and the light-emitting region 10 of the first color sub-pixel 101 is equal to the distance between the second defining structure 220 and the light-emitting region 10 of the third color sub-pixel 103.

In the display substrate provided by the example, the respective characteristics and relative position relationship of the first color sub-pixels 101, the second color sub-pixels 102 and the third color sub-pixels 103 are the same as those of the first color sub-pixels 101, the second color sub-pixels 102 and the third color sub-pixels 103 in the display substrate shown in Fig. 3 and Fig. 5, which will not be repeated here. In the display substrate provided by the example, the pixel defining pattern 300, the photo spacers 400, the base substrate 01 and other film layers between the first electrode 110 and the base substrate 01 may have the same characteristics as those of corresponding structures in the display substrate shown in Fig. 3 to Fig. 6, which will not be repeated here. The characteristics such as the cross section shape of the defining structures 200 in the display substrate provided by the example are the same as those of the defining structures 200 in the display substrate shown in Fig. 3 to Fig. 6, which will not be repeated here.

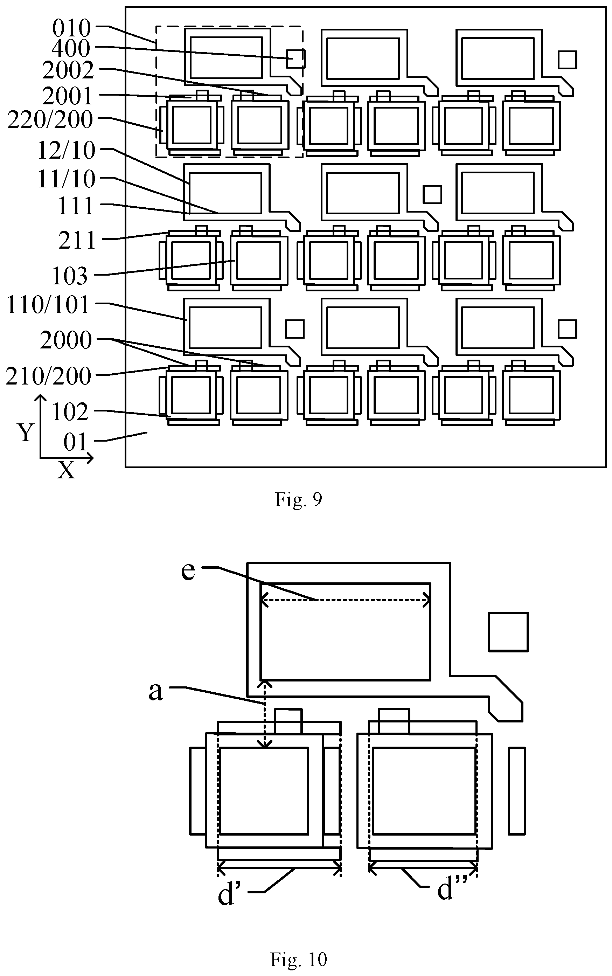

Fig. 9 is a schematic diagram of a partial planar structure of a display substrate according to another example of an embodiment of the present disclosure. Fig. 10 is a schematic diagram of a planar structure of one pixel unit shown in FIG. 9. The display substrate shown in Fig. 9 and Fig. 10 is different from the display substrate shown in Fig. 7 and Fig. 8 in that at least one first defining structure 210 includes two sub-defining structures 2000 which are arranged at intervals in the first direction.

For example, as shown in Fig. 9 and Fig. 10, the first defining structure 210 which is positioned on the same side of the same first color sub-pixel 101 and is arranged corresponding to the same first color sub-pixel includes two sub-defining structures 2000 which are arranged at intervals in the first direction, and the distance between two defining end points 211, which are far away from each other, of the two sub-defining structures 2000 is larger than the length of the first edge 11. For example, the sum of the lengths of the two sub-defining structures 2000 and the interval between the two sub-defining structures 2000 is the total length of the first defining structure 210, and the total length of the first defining structure 210 is larger than the length of the corresponding first edge 11. For example, the sum of the length of the two sub-defining structures 2000 is larger than the length of the corresponding first edge 11.

According to the display substrate provided by the example, the first defining structure is arranged to include two sub-defining structures which are arranged at intervals; and while the at least one layer of the light-emitting functional layer between the second color sub-pixel and the first color sub-pixel and the at least one layer of the light-emitting functional layer between the third color sub-pixel and the first color sub-pixel are isolated, the continuity of the second electrode can be improved, the increase of the cross voltage can be prevented, and the display uniformity can be improved.

In some examples, as shown in Fig. 9 and Fig. 10, the straight line extending in the second direction passes through the interval between the orthographic projections of the two sub-defining structures 2000 on the base substrate 01 and the interval between the orthographic projections of the light-emitting regions 10 of the second color sub-pixels 102 and the third color sub-pixels 103 on the base substrate 01. The interval between the two sub-defining structures 2000 is aligned with the interval between the second color sub-pixel 102 and the third color sub-pixel 103, so that the continuity of the second electrode 120 can be further improved, and the display uniformity can be improved.

For example, *a* and *e* shown in Fig. 10 can be the same as relevant parameters shown in Fig. 5, which will not be repeated here. For example, the length of one of the two sub-defining structures 2000 in the first direction is d', the length of the other one of the two sub-defining structures 2000 in the first direction is d", d'+d">*e*. For example, the length of the two sub-defining structures 2000 can be the same or different.

For example, as shown in Fig. 9 and Fig. 10, the sub-defining structure 2000, close to the second color sub-pixels 102, in the two sub-defining structures 2000 is a first sub-defining structure 2001; the sub-defining structure 2000, close to the third color sub-pixels 103, in the two sub-defining structures 2000 is a second sub-defining structure 2002; the first sub-defining structure 2001 is closer to the second sub-defining structure 2002 than the light-emitting region 10 of the second color sub-pixel 102; and the second sub-defining structure 2002 is closer to the first sub-defining structure 2001 than the light-emitting region 10 of the third color sub-pixel 103. For example, the first sub-defining structure 2001 is closer to the second sub-defining structure 2002 than the first electrode 110 of the second color sub-pixel 102, and the second sub-defining structure 2002 is farther from the first sub-defining structure 2001 than the first electrode 110 of the third color sub-pixel 103. By setting the position relationship between the sub-defining structures 2000 and the light-emitting regions 10 as well as the first electrodes 110 of the corresponding sub-pixels, the continuity of second electrode 120 can be improved while at least one side of the light-emitting functional layer 130 between the second color sub-pixel 102 and the first color sub-pixel 101, and between the third color sub-pixel 103 and the first color sub-pixel 101 is well isolated to reduce crosstalk.

For example, as shown in Fig. 9 and Fig. 10, only one of the straight lines which extend in the second direction and pass through the two second defining structures 220 located on the two sides of the second color sub-pixel 102 passes through the first sub-defining structure 2001. By setting the distance between the first sub-defining structure 200 and the light-emitting region 10 of the second color sub-pixel 102, and the distance between the two second defining structures 220 and the light-emitting region 10 of the second color sub-pixel 102, the channel proportion of the light-emitting functional layer 130 around the light-emitting region 10 of the second color sub-pixel 102 such as the red sub-pixels is reduced, and the crosstalk effect is alleviated.

In the display substrate provided by the example, the respective characteristics and relative position relationships of the first color sub-pixels 101, the second color sub-pixels 102 and the third color sub-pixels 103 are the same as those of the first color sub-pixels 101, the second color sub-pixels 102 and the third color sub-pixels 103 in the display substrates shown in Fig. 3, Fig. 5, Fig. 7 and Fig. 8, which will not be repeated here. In the display substrate shown in the example, the pixel defining pattern 300, the photo spacers 400, the base substrate 01 and other film layers between the first electrode 110 and the base substrate 01 can have the same characteristics as those of corresponding structures in the display substrate shown in Fig. 3 to Fig. 6, which will not be repeated here. The characteristics such as the cross section shape of the defining structures 200 in the display substrate shown in the example are the same as those of the defining structures 200 in the display substrate shown in Fig. 3 to Fig. 6, which will not be repeated here. In the display substrate shown in the example, the distance relationship between the second defining structures 220 and the light-emitting regions 10 of sub-pixel of different colors can be the same as the corresponding distance relationship in the display substrate shown in Fig. 7 and Fig. 8, but not limited thereto, the distance relationship between the second defining structures 220 and the light-emitting region 10 of the sub-pixels of different colors in the example may also be the same as the corresponding distance relationship in the display substrate shown in Fig. 3 to Fig. 6, which will not be repeated here.

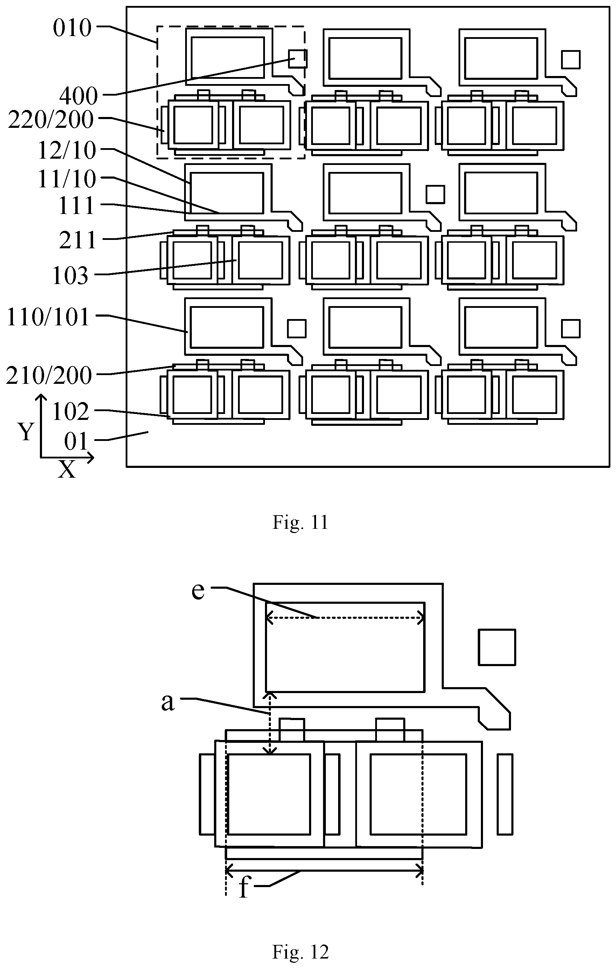

Fig. 11 is a schematic diagram of a partial planar structure of a display substrate according to another example of an embodiment of the present disclosure. Fig. 12 is a schematic diagram of a planar structure of one pixel unit shown in Fig. 11. The display substrate shown in Fig. 11 and Fig. 12 is different from the display substrate shown in Fig. 7 and Fig. 8 in that the relative position relationship between the first defining structure 210 and the light-emitting region 10 of the first color sub-pixel 101 is different, and the length of the first defining structure 210 is also different.

In some examples, as shown in Fig. 11 and Fig. 12, a distance between a straight line extending in the second direction which has an orthographic projection of one of the two defining end points 211 of the first defining structure 210 on the base substrate 01 and an orthographic projection of the second edge 12 of the light-emitting region 10 of the first color sub-pixel 101 on the base substrate 01 is less than 0.5 µm. For example, the distance between the straight line extending in the second direction which has the orthographic projection of one of the two defining end points 211 of the first defining structure 210 on the base substrate 01 and the orthographic projection of the second edge 12 of the light-emitting region 10 of the first color sub-pixel 101 on the base substrate 01 is less than 0.4 µm, or 0.3 µm, or 0.2 µm, or 0.1 µm and the like. For example, the orthographic projection of one of the two defining end points 211 of the first defining structure 210 on the base substrate 01 and the orthographic projection of the second edge 12 of the light-emitting region 10 of the first color sub-pixel 101 on the base substrate 01 are located on the same straight line. For example, the orthographic projection of one of the two defining end points 211 of the first defining structure 210 on the base substrate 01 is flush with the orthographic projection of one edge end point 111 of the first edge 11 of the light-emitting region 10 of the first color sub-pixel 101 on the base substrate 01, and the orthographic projection of the other defining end point 211 of the first defining structure 210 on the base substrate 01 protrudes relative to the orthographic projection of the other edge end point 111 of the first edge 11 of the light-emitting region 10 of the first color sub-pixel 101 on the base substrate 01. For example, in the same pixel unit 010, the defining end point 211, close to the third color sub-pixel 103, of the first defining structure 210 is flush with one edge end point 111 of the first edge 11 of the light-emitting region 10 of the first color sub-pixel 101, and the defining end point, close to the second color sub-pixel 102, of the first defining structure 210 protrude relative to the other edge end point 111 of the first edge 11 of the first color sub-pixel 101.

According to the display substrate provided by the example, by defining the position relationship between the two defining end points of the first defining structure and the two edge end points of the first edge of the first color sub-pixel, the crosstalk between the first color sub-pixel and the second color sub-pixel can be effectively reduced, meanwhile, the continuity of the second electrode of the first color sub-pixel and the third color sub-pixel is improved, and the display uniformity is improved.

For example, *a* and *e* shown in the Fig. 12 can be the same as relevant parameters shown in the Fig. 5, which will not be repeated here. For example, the length *f* of the first defining structure 210 and the length *e* of the first edge 11 meet f>e, thus at least one layer of the light-emitting functional layer 130 around the second color sub-pixel 102 such as the red sub-pixel is effectively isolated, and the crosstalk display effect is improved.

For example, as shown in Fig. 11 and Fig. 12, two straight lines which extend in the second direction and respectively pass through the orthographic projections of the two edge end points 111 of the first edge 11 of the light-emitting region 10 of the first color sub-pixel 101 on the base substrate 01 both pass through the orthographic projection of the first defining structure 210 on the base substrate 01. For example, two straight lines which extend in the second direction and respectively pass through the orthographic projections of two edges, extending in the second direction, of the light-emitting region 10 of the second color sub-pixel 102 on the base substrate 01 both pass through the orthographic projection of the first defining structure 210 on the base substrate 01. For example, only one straight line of two straight lines which extend in the second direction and respectively pass through the orthographic projections of two edges, extending in the second direction, of the light-emitting region 10 of the third color sub-pixel 103 on the base substrate 01 passes through the orthographic projection of the first defining structure 210 on the base substrate 01. By setting the position relationship of the first defining structures 210, the light-emitting regions 10 of the first color sub-pixels 101 and the light-emitting regions 10 of the second color sub-pixels 102, the crosstalk of the light-emitting regions 10 of the first color sub-pixels 101 and the light-emitting regions 10 of the second color sub-pixels 102 at an overlapping region in the second direction can be reduced, and meanwhile the continuity of the second electrodes 120 at a non-overlapping region of the light-emitting regions 10 of the second color sub-pixels 102 and the light-emitting regions 10 of the first color sub-pixels 101 in the second direction is improved.

In the display substrate provided by the example, the respective characteristics and relative position relationship of the first color sub-pixels 101, the second color sub-pixels 102 and the third color sub-pixels 103 are the same as those of the first color sub-pixels 101, the second color sub-pixels 102 and the third color sub-pixels 103 in the display substrates shown in Fig. 3 and Fig. 5 and Fig. 7 and Fig. 8, which will not be repeated here. The pixel defining pattern 300, the photo spacers 400, the base substrate 01 and other film layers between the first electrodes 110 and the base substrates 01 in the display substrate shown in the example may have the same characteristics as those of corresponding structures in the display substrate shown in Fig. 3 to Fig. 6, which will not be repeated here. The characteristics such as the cross section shape of the defining structures in the display substrate shown in the example are the same as those of the defining structures in the display substrates shown in Fig. 3 to Fig. 6, which will not be repeated here. The distance relationship between the second defining structures 220 and the light-emitting regions 10 of the sub-pixels of different colors illustrated in the display substrate shown in the example may be the same as the corresponding distance relationship in the display substrate shown in Fig. 7 and Fig. 8, but not limited thereto, the distance relationship between the second defining structures 220 and the light-emitting regions 10 of the sub-pixels of different colors shown in the example may also be the same as the corresponding distance relationship in the display substrate shown in Fig. 3 to Fig. 6, which will not be repeated here.

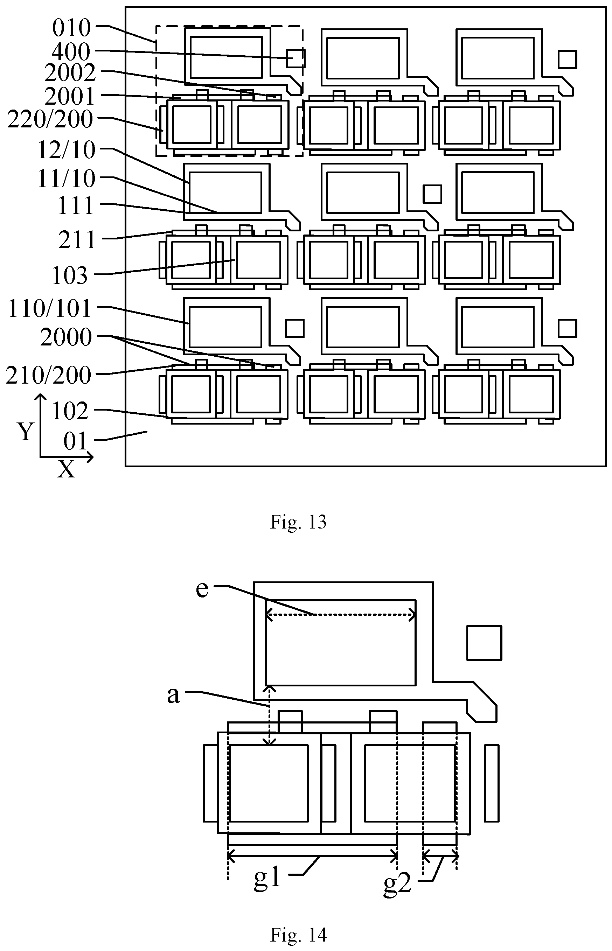

Fig. 13 is a schematic diagram of a partial planar structure of a display substrate according to another example of an embodiment of the present disclosure. Fig. 14 is a schematic diagram of a planar structure of one pixel unit shown in Fig. 13. The display substrate shown in Fig. 13 and Fig. 14 is different from the display substrate shown in Fig. 9 and Fig. 10 in that the relative position relationship of the first defining structure 210 to the light-emitting regions 10 of the first color sub-pixel 101, the second color sub-pixel 102 and the third color sub-pixel 103 is different.

In some examples, as shown in Fig. 13 and Fig. 14, at least one first defining structure 210 includes two sub-defining structures 2000 which are arranged at intervals along the first direction, and a straight line extending in the second direction passes through the interval between orthographic projections of the two sub-defining structures 2000 on the base substrate 01 and the orthographic projection of the light-emitting region 10 of the third color sub-pixel 103 on the base substrate 01.

For example, as shown in Fig. 13 and Fig. 14, the first defining structure 210 includes a first sub-defining structure 2001 corresponding to the second color sub-pixel 102 and a second sub-defining structure 2002 corresponding to the third color sub-pixel 103, and the length of the first sub-defining structure 2001 is larger than that of the second sub-defining structure 2002. For example, the sum of the length of the first sub-defining structure 2001, the second sub-defining structure 2002 and the interval between the first sub-defining structure 2001 and the second sub-defining structure 2002 in the first direction is larger than the length of the first edge 11 of the light-emitting region 10 of the first color sub-pixel 101. For example, one defining end point 211, far away from the second sub-defining structure 2002, of the first sub-defining structure 2001 protrudes relative to one edge end point 111 of the first edge 11, and one defining end point 211, far away from the first sub-defining structure 2001, of the second sub-defining structure 2002 protrudes relative to the other edge end point 111 of the first edge 11.

For example, as shown in Fig. 13 and Fig. 14, a straight line extending in the second direction passes through an interval between orthographic projections of the first sub-defining structure 2001 and the second sub-defining structure 2002 on the base substrate 01 and the orthographic projection of the light-emitting region 10 of the first color sub-pixel 101 on the base substrate 01.

For example, as shown in Fig. 13 and Fig. 14, two straight lines extending in the second direction respectively pass through two edges, extending in the second direction, of the light-emitting region 10 of the second color sub-pixel 102 and the first sub-defining structure 2001. For example, one straight line extending in the second direction passes through one edge, extending in the second direction, of the light-emitting region 10 of the third color sub-pixel 103 and the first sub-defining structure 2001, and the other straight line extending in the second direction passes through the other edge, extending in the second direction, of the light-emitting region 10 of the third color sub-pixel 103 and the second sub-defining structure 2002.

For example, as shown in Fig. 13 and Fig. 14, only one of two straight lines which extend in the second direction and pass through two second defining structures 220 located on the two sides of the second color sub-pixel 102 passes through the first sub-defining structure 2001. By setting the distance among the first sub-defining structure 2001, the two second defining structures 220 and the light-emitting region 10 of the second color sub-pixel 102, the channel proportion of the light-emitting functional layer 130 around the light-emitting region 10 of the second color sub-pixel 102, such as the red sub-pixel, can be reduced, and thus the crosstalk effect can be alleviated.

For example, as shown in Fig. 14, *a* and *e* can be the same as relevant parameters shown in Fig. 5, which will not be repeated here. For example, the length of the first sub-defining structure 2001 is g1, the length of the second sub-defining structure 2002 is g2, g1+g2>*e*, the effective isolating of at least one layer of the light-emitting functional layer 130 around the second color sub-pixel 102, such as the red sub-pixel, can be realized, and the crosstalk display effect is improved.

In the display substrate provided by the example, the respective characteristics and relative position relationship of the first color sub-pixels 101, the second color sub-pixels 102 and the third color sub-pixels 103 are the same as those of the first color sub-pixels 101, the second color sub-pixels 102 and the third color sub-pixels 103 in the display substrates shown in Fig. 3, Fig. 5, Fig. 7 and Fig. 8, which will not be repeated here. The pixel defining pattern 300, the photo spacers 400, the base substrate 01 and other film layers between the first electrodes 110 and the base substrate 01 in the display substrate shown in the example may have the same characteristics as those of corresponding structures in the display substrate shown in Fig. 3 to Fig. 6, which will not be repeated here. The characteristics such as the cross section shape of the defining structures 200 in the display substrate shown in the example are the same as those of the defining structures 200 in the display substrate shown in Fig. 3 to Fig. 6, which will not be repeated here. The distance relationship between the second defining structures 220 and the light-emitting regions 10 of the sub-pixels of different colors illustrated in the display substrate shown in the present example may be the same as the corresponding distance relationship in the display substrate shown in Fig. 7 and Fig. 8, but not limited thereto, and the distance relationship between the second defining structures 220 and the light-emitting regions 10 of the sub-pixels of different colors shown in the present example may also be the same as the corresponding distance relationship in the display substrates shown in Fig. 3 to Fig. 6, which will not be repeated here.

For example, in other examples, the second defining structures 220 are closer to the light-emitting regions 10 of the second color sub-pixels 102, and the distance between the first defining structure 210 and the light-emitting region 10 of the first color sub-pixel 101 may be equal to the distance between the first defining structure 210 and the light-emitting region 10 of the second color sub-pixel 102. For example, the second defining structure 220 located between adjacent sub-pixels can be of a continuous structure and can also include a plurality of sub-defining structures 2000 arranged at intervals.

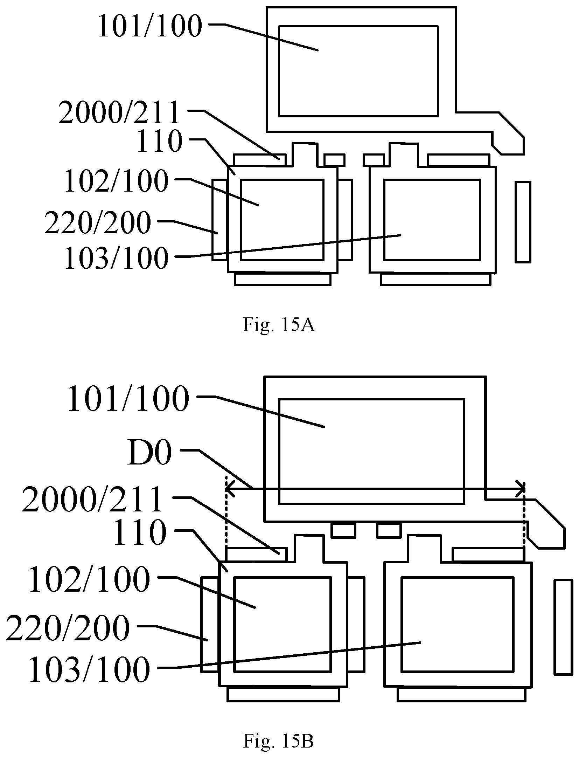

Fig. 15A and Fig. 15B are schematic diagrams of a planar structure of a pixel unit according to different examples of an embodiment of the present disclosure. The difference between the pixel units shown in Fig. 15A and Fig. 15B and the pixel unit shown in Fig. 9 is that the first defining structure 210 is not overlapped with the first electrode 110 of each sub-pixel in the direction perpendicular to the base substrate.

For example, as shown in Fig. 15A and Fig. 15B, in the direction perpendicular to the base substrate, the first defining structure 211 is not overlapped with the first electrodes 110 of the second color sub-pixel 102 and the third color sub-pixel 103, so that an anode via hole is avoided, and the first defining structure are prevented from being deformed due to depression at the position of the anode via hole.

For example, as shown in Fig. 15A, the first defining structure 211 located between the second color sub-pixel 102 and the first color sub-pixel 101 of the same pixel unit may include a plurality of sub-defining structures 2000, such as two sub-defining structures 2000, arranged in the first direction. For example, the first defining structure 211 located between the third color sub-pixel 103 and the first color sub-pixel 101 of the same pixel unit may include a plurality of sub-defining structures 2000, such as two sub-defining structures 2000, arranged in the first direction, for example, four sub-defining structures 2000 can be arranged between the same first color sub-pixel 101 and other color sub-pixels. For example, only one sub-defining structure 2000 can be arranged on the side, away from the first color sub-pixel 101, of the second color sub-pixel 102 of the same pixel unit. For example, only one sub-defining structure 2000 can be arranged on the side, away from the first color sub-pixel 101, of the third color sub-pixel 103 of the same pixel unit.

For example, as shown in Fig. 15B, in the plurality of sub-defining structures 2000 located between the first color sub-pixel 101 and the second color sub-pixel 102 of the same pixel unit, at least one sub-defining structure 2000 is close to the first color sub-pixel 101, and at least one sub-defining structure 2000 is close to the second color sub-pixel 102. For example, in the plurality of sub-defining structures 2000 between the first color sub-pixel 101 and the third color sub-pixel 103, at least one sub-defining structure 2000 is close to the first color sub-pixel 101, and at least one sub-defining structure 2000 is close to the third color sub-pixel 103. By arranging the positions of the different sub-defining structures, the continuity of the second electrodes around light-emitting regions of the sub-pixels of different colors can be adjusted.

The distance between the two defining end points of the first defining structure shown in Fig. 15B can be D0.

Other structures in the display substrates shown in Fig. 15A and Fig. 15B may have the same characteristics as other structures in the display substrate shown in Fig. 9, which will not be repeated here.

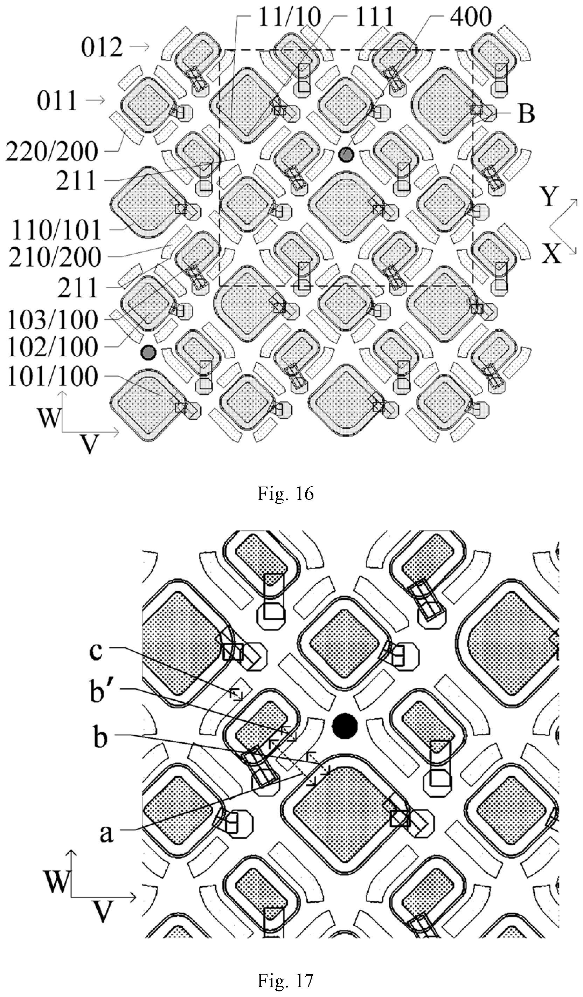

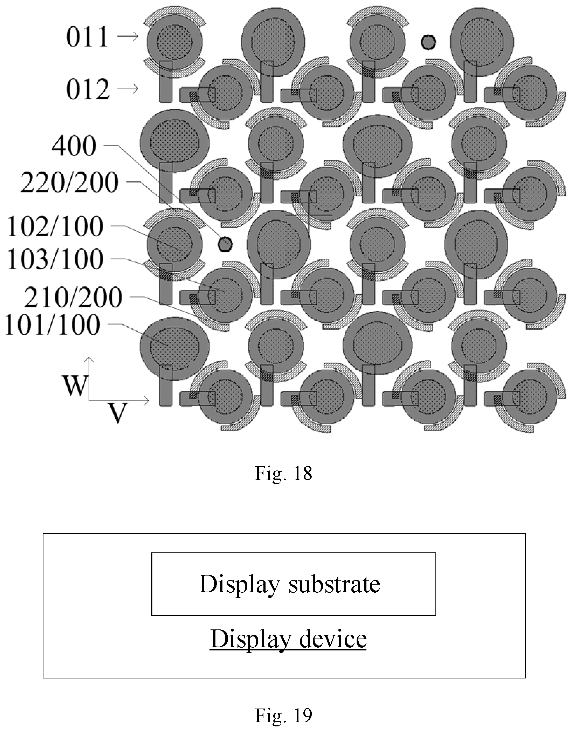

Fig. 16 and Fig. 18 are schematic diagrams of local plane structures of display substrates by different examples according to an embodiment of the present disclosure. Fig. 17 is an enlarged diagram of a region B in the display substrate shown in Fig. 16.

The difference between the display substrate shown in Fig. 16 and the display substrates shown in Fig. 3 to Fig. 14 includes: different pixel arrangement structures, different shapes of the light-emitting regions 10 of the sub-pixels 100 with respective colors, and different plane shape and length of the defining structures 200.

In some examples, as shown in Fig. 16 and Fig. 17, the plurality of sub-pixels 100 includes a plurality of second color sub-pixels 102 and a plurality of third color sub-pixels 103; the plurality of sub-pixels 100 is arranged into a plurality of first sub-pixel groups 011 and a plurality of second sub-pixel groups 012 which are alternately arranged in a third direction; each first sub-pixel group 011 includes first color sub-pixels 101 and second color sub-pixels 102 which are alternately arranged in a fourth direction; each second sub-pixel group 012 includes third color sub-pixels 103 arranged in the fourth direction; the third direction intersects with the fourth direction; and the third direction and the fourth direction both intersect with the first direction. For example, the plurality of sub-pixels can be arranged into a blue-diamond pixel array.

The third direction can be a W direction shown in the figure or a direction opposite to the direction pointed by the arrow of the W direction, and the fourth direction can be a V direction shown in the figure or a direction opposite to the direction pointed by an arrow of the V direction. For example, the third direction and the fourth direction both intersect with the second direction. For example, the third direction and the fourth direction can be perpendicular to each other. For example, the third direction and the fourth direction can be interchanged, which is not limited in the embodiment of the present invention. In the example, the colors of light emitted the sub-pixels in the first color sub-pixels 101, the second color sub-pixels 102 and the third color sub-pixels 103 can be the same as the above example, which will not be repeated here.

For example, as shown in Fig. 16 and Fig. 17, the shape of the light-emitting region 10 of the first color sub-pixel 101 can be a shape with four corners, the four corners can be arc-shaped, and the radian of one of the four corners is larger than that of the other three corners. For example, the shape of the light-emitting regions 10 of the second color sub-pixel 102 and the third color sub-pixel 103 can be quadrangles, such as quadrangles with round corners.

For example, as shown in Fig. 16 and Fig. 17, the area of the light-emitting region 10 of each first color sub-pixel 101 is larger than that of the light-emitting region 10 of each second color sub-pixel 102, and the area of the light-emitting region 10 of each second color sub-pixel 102 is larger than that of the light-emitting region 10 of each third color sub-pixel 103.

In some examples, as shown in Fig. 16 and Fig. 17, the first defining structure 210 is located between the first color sub-pixel 101 and the third color sub-pixel 103, and the distance between the first defining structure 210 and the light-emitting region 10 of the first color sub-pixel 101 is larger than the distance between the first defining structure 210 and the light-emitting region 10 of the third color sub-pixel 103. For example, the first defining structure 210 is closer to the light-emitting region 10 of the third color sub-pixel 103. Therefore, the defining structures 200 can be distributed among the sub-pixels 100 of different colors in different pixel arrangement structures, such as being arranged close to the red sub-pixel or the green sub-pixel which easily causes crosstalk, so that at least one layer of the light-emitting functional layer 130 of the different color sub-pixels 100 is disconnected, and the crosstalk is reduced.

For example, as shown in Fig. 17, the distance (such as PDL gap) between the light-emitting regions 10 of the adjacent sub-pixels 100 is *a,* the distance between the first defining structure 210 and the light-emitting region 10 of the first color sub-pixel 101 is *b*, the length of the side, close to the base substrate 01, of the section perpendicular to the first direction of the first defining structure 210 is *c*, and the distance between the first defining structure 210 and the light-emitting region 10 of the third color sub-pixel 103 is b', *b >* b'. The section shape and the size characteristic of the defining structures 200 in the example may be the same as those of the defining structures 200 in the above examples, which will not be repeated here.

For example, as shown in Fig. 16 and Fig. 17, only one defining end point 211 of the first defining structure 210 protrudes relative to the edge end point 111 of the first edge 11 of the light-emitting region 10 of the first color sub-pixel 101, and a straight line extending in the second direction passes through an orthographic projection of the other defining end point 211 of the first defining structure 210 on the base substrate 01 and an orthographic projection of the first edge 11 on the base substrate 01. For example, the distance between the two defining end points 211 of the first defining structure 210 is larger than the length of the first edge 11 of the first color sub-pixel 101. For example, the length of the first defining structure 210 is larger than the length of the first edge 11 of the first color sub-pixel 101.

In some examples, as shown in Fig. 16 and Fig. 17, the edge, close to the first defining structure 210, of the third color sub-pixel 103 extends in the first direction. For example, two edges, close to the first color sub-pixel 101 and the third color sub-pixel 103, of the orthographic projection of the first defining structure 210 on the base substrate 01 are two first defining edges; at least one first defining edge includes a part extending in the first direction and a bent part; the orthographic projection of the first defining structure 210 on the base substrate 01 further includes two second defining edges connecting the two first defining edges; and the length of the first defining edge is larger than that of the second defining edge.

For example, as shown in Fig. 16 and Fig. 17, the second defining structure 220 is located between the second color sub-pixel 102 and the third color sub-pixel 103. For example, the second defining structures 220 are closer to the second color sub-pixels 102. For example, the distance between the first defining structure 210 and the light-emitting region 10 of the third color sub-pixel 103 is different from the distance between the second defining structure 220 and the light-emitting region 10 of the third color sub-pixels 103. For example, the distance between the first defining structure 210 and the light-emitting region 10 of the third color sub-pixel 103 is less than the distance between the second defining structure 220 and the light-emitting region 10 of the third color sub-pixel 103. For example, two edges, close to the second color sub-pixel 102 and the third color sub-pixel 103, of the orthographic projection of the second defining structure 220 on the base substrate 01 are two third defining edge, and at least one third defining edge includes a part extending in the second direction and a bent part.

For example, as shown in Fig. 16 and Fig. 17, the second defining structure 220 surrounds the light-emitting region 10 of the second color sub-pixel 102. For example, the first defining structure 210 surrounds the light-emitting region 10 of the first color sub-pixel 102.

Fig. 16 and Fig. 17 illustratively show that the first defining structure 210 and the second defining structure 220 between adjacent sub-pixels are both continuous structures, but not limited, at least one first defining structure 210 and at least one second defining structure 220 may include a plurality of sub-defining structures arranged at intervals.

In the display substrate provided by the example, the base substrate 01, the film layers between the first electrodes 110 of the sub-pixels 100 and the base substrate 01 may have the same characteristics as the corresponding structures in any one of the above examples, which will not be repeated here. The layer relationship and the characteristics such as materials of the photo spacers 400 and the defining structures 200 in the display substrate provided by the example may have the same characteristics as the corresponding structures in any one of the above examples, which will not be repeated here. The plane shape of the photo spacer 400 shown in the figure is circular, but not limited, the plane shape of the photo spacer 400 may also be quadrilateral or other shapes.

The pixel arrangement structure of the display substrate shown in Fig. 18 is the same as that of the display substrate shown in Fig. 16, for example, the pixel arrangement structure includes the first sub-pixel group 011 and the second sub-pixel group 012. The display substrate shown in Fig. 18 is different from the display substrate shown in Fig. 16 in the aspects of the shape of the light-emitting regions 10 of the sub-pixels 100, the shape of the first electrodes 110 of the sub-pixels 100 and the plane shape of the defining structures 200. For example, the plane shape of the defining structures 200 can be in an arc shape or other non-linear special shapes.

As shown in Fig. 18, the first defining structure 210 has bent shape, and the total length of the first defining structure 210 is larger than the size of the light-emitting region 10 of the first color sub-pixel 101 in at least one direction. For example, the total length of the first defining structure 210 is greater than the size of the light-emitting region 10 of the first color sub-pixel 101 in the first direction, or larger than the size of the light-emitting region 10 of the first color sub-pixel 101 in the second direction, or larger than the size of the light-emitting region 10 of the first color sub-pixel 101 in the third direction, or larger than the size of the light-emitting region 10 of the first color sub-pixel 101 in the fourth direction, or larger than the size of the light-emitting region 10 of the first color sub-pixel 101 in other directions. By setting the shape of the first defining structure 210 and the size relationship between the total length of the first defining structure 210 and the size of the light-emitting region 10 of the first color sub-pixel 101, the shape of the first defining structure 210 can be matched with the shape of the light-emitting region 10 of the sub-pixel, meanwhile, the problem of low grayscale crosstalk caused by leakage of current between the first color sub-pixels 101 and other color sub-pixels 100 is reduced, and the possibility that the first defining structure 210 are peeled is reduced.

In some examples, as shown in Fig. 18, the edges of the light-emitting regions 10 of the third color sub-pixels 103 have curved shape, and the first defining structures 210 are curved toward the light-emitting regions 10 of the third color sub-pixels 103. For example, the first defining structures 210 are curved in a direction away from the light-emitting regions 10 of the first color sub-pixels 101. By bending the first defining structure 210 in the direction toward the light-emitting region 10 of the third color sub-pixel 103, the first defining structure 210 can be closer to the light-emitting region 10 of the third color sub-pixel 103, and thus the crosstalk of the third color sub-pixel 103 to the first color sub-pixel 101 is reduced.

For example, as shown in Fig. 18, the light-emitting regions 10 of the second color sub-pixels 102 and the third color sub-pixels 103 are both circular, the edges of the light-emitting regions 10 of the first color sub-pixels 101 include a curve, for example, a plurality of sequentially connected curve sections, and the curvatures of the curve sections of the light-emitting region 10 of the same first color sub-pixel 101 in different directions can be different to reduce color cast.

For example, as shown in Fig. 18, the light-emitting region 10 of the same third color sub-pixel 103 is surrounded by two curved first defining structures 210, and the first defining structures 210 are closer to the light-emitting region 10 of the third color sub-pixel 103. Certainly, the embodiment of the present disclosure is not limited to that the light-emitting region 10 of the third color sub-pixel 103 is surrounded by two first defining structures 210, and may also be surrounded by one or more first defining structures 210.

In some examples, as shown in Fig. 18, the plurality of defining structures 200 further includes a plurality of second defining structures 220 which are at least located between adjacent second color sub-pixels 102 and third color sub-pixels 103, and the distance between the second defining structures 220 and light-emitting regions 10 of the second color sub-pixels 102 is less than the distance between the second defining structures 220 and light-emitting regions 10 of the third color sub-pixels 103.

For example, as shown in Fig. 18, the second defining structures 220 have bent shapes and are bent toward the light-emitting regions 10 of the second color sub-pixels 102. For example, the second defining structures 220 are bent in the direction away from the light-emitting regions 10 of the third color sub-pixels 103. By bending the second defining structures 220 in the direction toward the light-emitting regions 10 of the second color sub-pixels 102, the second defining structures 220 can be closer to the light-emitting regions 10 of the second color sub-pixels 102, and crosstalk of the second color sub-pixels 102 to first color sub-pixels 101 and the third color sub-pixels 103 is reduced.

For example, as shown in Fig. 18, the light-emitting region 10 of the same second color sub-pixel 102 is surrounded by two bent second defining structures 220, and the second defining structures 220 are closer to the light-emitting region 10 of the second color sub-pixel 102. Certainly, the embodiments of the present disclosure are not limited to that the light-emitting region 10 of the second color sub-pixel 102 is surrounded by the two second defining structures 220, and may also be surrounded by one or more second defining structures 220.

Fig. 18 illustrates that the first defining structure 210 and the second defining structure 220 located between adjacent sub-pixels are both continuous structures, but not limited to, at least one first defining structure 210 and at least one second defining structure 220 may include a plurality of sub-defining structures arranged at intervals.

In the display substrate provided by the example, the base substrate 01, the film layers between the first electrodes 110 of the sub-pixels and the base substrate 01 may have the same characteristics as the corresponding structures in any one of the above examples, which will not be repeated here. The layer relationship and the characteristics such as the material of the photo spacers 400 and the defining structures in the display substrate may have the same characteristics as the corresponding structures in any one of the above examples, which will not be repeated here. The plane shape of the photo spacers 400 is shown to be circular in the figure, but not limited thereto, the plane shape of the photo spacers 400 can also be quadrilateral or other shapes. The color film can be arranged on the encapsulation layer of the display substrate provided by the example, such as forming a COE product.

According to the display substrate provided by the present disclosure, by setting the relative position relationship, relative distance and relative size of the defining structures and the light-emitting regions of the sub-pixels of different colors, poor crosstalk display caused by the material in the light-emitting functional layers is alleviated, and the problem of low-grayscale crosstalk caused by leakage of current between the red, green and blue sub-pixels due to the Tandem technology is solved.

The display substrate provided by the present disclosure can be applied to a folding display panel, and technical feasibility is established for strengthening the toughness of the display panel, preventing the display panel from peeling and the like.

The defining structure provided by the present disclosure can be suitable for various different pixel arrangement structures, such as Diamond, Diamond-like, Pentile arrangement, sRGB, and COE circular pixel arrangement, so that crosstalk caused by the at least one layer of the light-emitting functional layer of the sub-pixels of different colors is reduced.

Fig. 19 is a schematic block diagram of a display device according to another embodiment of the present disclosure. As shown in Fig. 19, the display device provided by the embodiments of the present disclosure includes any one of the above display substrates.

For example, the display device further includes a cover plate on a light-emitting side of the display substrate.

For example, the display device can be a display device such as an organic light-emitting diode display device and any product or part with a display function, such as a television, a digital camera, a mobile phone, a watch, a tablet personal computer, a notebook computer and a navigator including the display device, the embodiment is not limited to these.

For example, the display device can be a medium-large-size display product, for example, the diagonal length of the display surface of the display device is more than 10 inches, such as 20 inches.

For example, the display device can be applied to mobile phones, vehicle-mounted products and folding products.

The following statements should be noted:
(1) The accompanying drawings involve only the structure(s) in connection with the embodiment(s) of the present disclosure, and other structure(s) can be referred to common design(s).
(2) In case of no conflict, features in one embodiment or in different embodiments can be combined.

What have been described above are only specific implementations of the present disclosure, the protection scope of the present disclosure is not limited thereto. The protection scope of the present disclosure should be based on the protection scope of the claims.

## Claims

1. A display substrate, comprising:
a base substrate;
a plurality of sub-pixels, located on the base substrate, each of at least part of the sub-pixels comprising a light-emitting functional layer which comprises a plurality of film layers; and
a plurality of defining structures, located between at least two adjacent sub-pixels with different colors, and configured to isolate at least one layer of the light-emitting functional layer;
wherein the plurality of sub-pixels comprises a plurality of first color sub-pixels, and a defining structure, adjacent to at least one first color sub-pixel, in the plurality of defining structures is a first defining structure;
at least part of the first defining structure extends in a first direction, a light-emitting region of the first color sub-pixel comprises a first edge extending in the first direction; the first defining structure comprises two defining end points; and in the first direction, at least one defining end point protrudes relative to an edge end point, close to the at least one defining end point, of the corresponding first edge, or, the first defining structure has a bent shape, and a total length of the first defining structure is larger than a size of the light-emitting region of the first color sub-pixel in at least one direction.

2. The display substrate according to claim 1, wherein a distance between the two defining end points of the first defining structure is larger than a length of the first edge.

3. The display substrate according to claim 1 or 2, wherein a total length of a part, extending in the first direction, of the first defining structure is larger than a length of the first edge.

4. The display substrate according to any one of claims 1 to 3, wherein a shape of a cross section, cut by a plane perpendicular to an extending direction of the defining structure comprises an inverted trapezoid; a base angle between a waist of the inverted trapezoid and a base edge, away from the base substrate, of the inverted trapezoid ranges from 50° to 80°; a length of a base edge, close to the base substrate, of the inverted trapezoid ranges from 1 µm to 6 µm; and a thickness of the defining structure ranges from 0.8 µm to 1.8 µm.

5. The display substrate according to any one of claims 1 to 4, wherein an orthographic projection of the first edge on the base substrate is a first orthographic projection, an orthographic projection of the first defining structure on the base substrate is a second orthographic projection, and an orthographic projection of the first orthographic projection on a straight line extending in the first direction is completely located in an orthographic projection of the second orthographic projection on the straight line.

6. The display substrate according to claim 1, wherein the light-emitting region of the first color sub-pixel further comprises a second edge extending in a second direction, the second direction intersects with the first direction; and
a distance between a straight line which has an orthographic projection of one of the two defining end points on the base substrate and extends in the second direction, and an orthographic projection of the second edge on the base substrate is less than 0.5 µm.

7. The display substrate according to any one of claims 1 to 5, wherein the plurality of sub-pixels comprises a plurality of pixel units, the plurality of pixel units is arranged in an array along the first direction and the second direction, and the second direction intersects with the first direction;
each pixel unit comprises one first color sub-pixel, one second color sub-pixel and one third color sub-pixel; and the one first color sub-pixel and the one second color sub-pixel are arranged in the second direction, and the one second color sub-pixel and the one third color sub-pixel are arranged in the first direction; and
at least one side of the same first color sub-pixel in the second direction is provided with the first defining structure which is closely adjacent to the first color sub-pixel.

8. The display substrate according to claim 7, wherein the first color sub-pixel is a blue sub-pixel, one of the second color sub-pixel and the third color sub-pixel is a red sub-pixel, and the other one is a green sub-pixel.

9. The display substrate according to claim 7 or 8, wherein the first defining structure is located between the first color sub-pixel and the second color sub-pixel, and a first distance between the first defining structure and a light-emitting region of the second color sub-pixel is less than a second distance between the first defining structure and the light-emitting region of the first color sub-pixel.

10. The display substrate according to claim 9, wherein a difference between the second distance and the first distance is not less than 1 µm.

11. The display substrate according to claim 7 or 8, wherein the first defining structure is located between the first color sub-pixel and the second color sub-pixel, and a ratio of a distance between the first defining structure and a light-emitting region of the second color sub-pixel to a distance between the first defining structure and the light-emitting region of the first color sub-pixel is 0.9-1.1.

12. The display substrate according to any one of claims 7 to 11, wherein at least one first defining structure comprises two sub-defining structures which are arranged at intervals in the first direction; and a straight line extending in the second direction passes through an interval between orthographic projections of the two sub-defining structures on the base substrate and an interval between orthographic projections of light-emitting regions of the second color sub-pixel and the third color sub-pixel on the base substrate.

13. The display substrate according to any one of claims 7 to 11, wherein at least one first defining structure comprises two sub-defining structures which are arranged at intervals in the first direction; and a straight line extending in the second direction passes through an interval between orthographic projections of the two sub-defining structures on the base substrate and an orthographic projection of a light-emitting region of the third color sub-pixel on the base substrate.

14. The display substrate according to any one of claims 7 to 13, wherein the plurality of defining structures further comprises a plurality of second defining structures which are at least located between the second color sub-pixel and the third color sub-pixel adjacent to each other.

15. The display substrate according to claim 14, wherein a third distance between the second defining structure and a light-emitting region of the second color sub-pixel is less than a fourth distance between the second defining structure and a light-emitting region of the third color sub-pixel.

16. The display substrate according to claim 14, wherein a ratio of a distance between the second defining structure and a light-emitting region of the second color sub-pixel to a distance between the second defining structure and a light-emitting region of the third color sub-pixel is 0.9-1.1.

17. The display substrate according to any one of claims 1 to 16, further comprising:
a pixel defining pattern located on the base substrate, wherein the pixel defining pattern comprises a plurality of openings and a pixel defining portion surrounding the openings, and the openings are configured to define the light-emitting regions of at least part of the sub-pixels; and
a plurality of photo spacers located on a side, away from the base substrate, of the pixel defining pattern,
wherein a distance between light-emitting regions of adjacent sub-pixels is 10-30 µm; and the plurality of defining structures and the plurality of photo spacers are arranged in a same layer and are made of a same material, and a height of at least part of the photo spacers is larger than that of the plurality of defining structures.

18. The display substrate according to any one of claims 1 to 5, wherein the plurality of sub-pixels comprises a plurality of second color sub-pixels and a plurality of third color sub-pixels; the plurality of sub-pixels are arranged into a plurality of first sub-pixel groups and a plurality of second sub-pixel groups which are alternately arranged in a third direction; each first sub-pixel group comprises first color sub-pixels and second color sub-pixels which are alternately arranged in a fourth direction; each second sub-pixel group comprises third color sub-pixels arranged in the fourth direction; the third direction intersects with the fourth direction; and the third direction and the fourth direction both intersect with the first direction; and
the first defining structure is located between the first color sub-pixel and the third color sub-pixel, and a distance between the first defining structure and the light-emitting region of the first color sub-pixel is larger than a distance between the first defining structure and a light-emitting region of the third color sub-pixel.

19. The display substrate according to claim 18, wherein an edge, adjacent to the first defining structure, of the third color sub-pixel extends in the first direction.

20. The display substrate according to claim 18, wherein an edge of the light-emitting region of the third color sub-pixel has a curved shape, and the first defining structure is curved toward the light-emitting region of the third color sub-pixel.

21. The display substrate according to any one of claims 18 to 20, wherein the plurality of defining structures further comprises a plurality of second defining structures which are at least located between adjacent second color sub-pixels and third color sub-pixels, and a distance between the second defining structure and the light-emitting region of the second color sub-pixel is less than a distance between the second defining structure and light-emitting region of the third color sub-pixel.

22. A display device, comprising the display substrate according to any one of claims 1 to 21.
